# EUROPÄISCHE PATENTSCHRIFT

(11) **EP 4 499 566 B1**
(45) Veröffentlichungstag und Bekanntmachung des Hinweises auf die Patenterteilung: **24.12.2025**
(21) Anmeldenummer: 23711107.5
(22) Anmeldetag: 22.03.2023
(51) Int. Cl.: B81B 7/00, H01Q 1/38

(54) **VERWENDUNG VON MEMS-PACKAGES ALS ANTENNENSUBSTRAT**
USE OF MEMS PACKAGES AS ANTENNA SUBSTRATE
UTILISATION DE BOÎTIERS MEMS COMME SUBSTRAT D'ANTENNE

(30) Priorität: 25.03.2022 EP 22164360
(43) Veröffentlichungstag der Anmeldung: 05.02.2025
(73) Patentinhaber: Hahn-Schickard-Gesellschaft für angewandte Forschung e. V., 70569 Stuttgart (DE)
(72) Erfinder: BITTNER, Achim, 74080 Heilbronn (DE); SIKORA, Axel, 79423 Heitersheim (DE); DEHÉ, Alfons, 72770 Reutlingen (DE)
(74) Vertreter: Hertin und Partner Rechts- und Patentanwälte PartG mbB
(86) Internationale Anmeldenummer: PCT/EP2023/057319
(87) Internationale Veröffentlichungsnummer: WO 2023/180376

(56) Entgegenhaltungen:
- JP-A- H09 237 867
- US-A1- 2011 100 123

## Beschreibung

Die Erfindung betrifft ein MEMS-Package, welches ein Packagesubstrat sowie mindestens ein MEMS-Element umfasst. Das mindestens eine MEMS-Element umfasst einen MEMS-Interaktionsbereich und ist in dem Packagesubstrat derart eingebettet, dass mindestens der MEMS-Interaktionsbereich frei bleibt. Das MEMS-Package zeichnet sich dadurch aus, dass auf oder in dem Packagesubstrat eine oder mehrere Antennen zum Senden und/oder Empfangen von elektromagnetischen Signalen vorliegen, wobei das Packagesubstrat als Antennensubstrat für die eine oder mehreren Antennen fungiert.

Zudem betrifft die Erfindung ein Verfahren zur Herstellung des erfindungsgemäßen MEMS-Packages. Dazu wird zunächst das Packagesubstrat und/oder Leiterbahnen durch ein additives Fertigungsverfahren bereitgestellt, bevorzugt durch ein multimaterielles additives Fertigungsverfahren. Daraufhin erfolgt eine mindestens teilweise Einbettung des mindestens einen MEMS-Elementes in das Packagesubstrat, sodass mindestens der MEMS-Interaktionsbereich frei bleibt. Des Weiteren werden die eine oder mehreren Antennen auf oder in dem Packagesubstrat angebracht.

### Hintergrund und Stand der Technik

Für die Herstellung kompakter, mechanisch-elektronischer Vorrichtungen wird heute auf vielen Anwendungsgebieten auf die Mikrosystemtechnik zurückgegriffen. Die so herstellbaren Mikrosysteme (englisch: microelectromechanical system, kurz MEMS, auch MEMS-Bauteil oder MEMS-Element genannt) sind sehr kompakt (ca. im Mikrometerbereich) bei gleichzeitig hervorragender Funktionalität und immer geringeren Herstellungskosten.

Da viele MEMS-Elemente eine hohe Empfindlichkeit gegenüber äußeren Einflüssen aufweisen, ist man bestrebt, diese besonders zu schützen. Dazu ist im Stand der Technik die Bereitstellung eines sogenannten Packagings bekannt. Dabei erfüllt das Packaging von MEMS-Elementen mehrere Aufgaben. Dazu gehört der Schutz des MEMS-Elementes vor Umweltfaktoren, wie z. B. Feuchte und/oder Flüssigkeiten ebenso wie Staub und/oder elektrostatischen Entladungen (ESD). Gleichzeitig sollen jedoch die funktionellen Eigenschaften des MEMS-Elementes, beispielsweise die akustischen Eigenschaften eines akustischen MEMS-Wandlers, erhalten bleiben. Mithin sollte das MEMS-Element mit seiner Umgebung interagieren können beispielsweise zur Aufnahme oder Detektion von Schalldruckwellen, wie im Falle eines akutstischen MEMS-Wandlers. Damit erfüllt das Packaging vorzugsweise eine Gehäusefunktion für das MEMS-Element. Auf einer Unterseite des MEMS-Elementes kann ein Substrat selbst diese Funktion erfüllen. Zusätzlich kann oberhalb des Substrates für die auf dem Substrat angeordneten Komponenten Schutz benötigt werden.

In Dehé et al. (2013) wird ein MEMS-Wandler offenbart, der eine Metallabdeckung als Packaging aufweist. Diese Abdeckung schließt ein Volumen ein, welches deutlich größer ist als theoretisch für die darunter liegenden Komponenten des MEMS-Wandler benötigt wird. Der Hauptgrund hierfür ist, dass ein Abstand zwischen Abdeckung und den teils elektrisch leitenden Komponenten (z. B. Drahtbonds, Elektroden, kapazitiver MEMS-Transducer etc.) eingehalten werden soll, um Kurzschlüsse zu vermeiden. Gleichzeitig ist Metall als Ausgangsmaterial für diese Abdeckungen erwünscht, da es mechanisch stabil und hermetisch dicht ist, insbesondere gegenüber Wasser und Luft. Zudem können empfindliche Komponenten elektromagnetisch abgeschirmt werden. So können negative Beeinflussungen und elektrostatische Entladungen vermieden werden.

In der WO 2022/008338 A1 wird ein MEMS-Package offenbart, das ein Substrat sowie ein auf dem Substrat angeordnetes MEMS-Element umfassend einen MEMS-Interaktionsbereich aufweist. Zum Schutz des MEMS-Elementes wird eine dielektrische Schicht aufgetragen, die durch eine oberflächenkonforme Beschichtung von dem MEMS-Element durch ein Beschichtungsverfahren mit einem Dielektrikum erfolgt. Dabei wird vorteilhaft eine kompakte Schutzschicht des bereitgestellt, die eine elektrische Isolierung und einen mechanischen Schutz des MEMS-Elementes bietet.

In Izadpanah et al. (2019) werden eine Übersicht verschiedener Packaging-Materialien und verschiedene Bauweisen offenbart. Packagingmaterialien, die für hochwertige Funktionen ausgelegt sind, umfassen häufig Keramik und sind in der Regel materialundurchlässig. Für Hochleistungsanwendungen werden Materialien wie Aluminiumnitrid und Siliziumkarbid verwendet, um optimierte thermischen Eigenschaften zu etablieren. Packagings umfassend Kunststoff werden insbesondere eingesetzt, sofern niedrige Herstellungskosten gewünscht sind. Die Art und Ausführung des Packagings hängt damit maßgeblich vom konkreten Anwendungsfall und damit auch vom MEMS-Element selbst ab.

Nachteilig an bekannten MEMS-Packages ist es, dass zumeist verschiedene MEMS-Elemente separat gepackaged werden, wodurch eine Integration von Arrays von MEMS-Elementen erschwert wird.

Zudem wäre es für viele Anwendungen wünschenswert, MEMS-Elemente in funktionaler Kombination mit Antennen zum Empfangen und/oder Versenden von elektromagnetischen Signalen bereitzustellen, um beispielsweise einen kabellosen Datenaustausch zu ermöglichen.

Dies ist insbesondere für jene Anwendungsfälle von Bedeutung, in denen elektromagnetische Signale mit weiteren Signalen, die durch MEMS-Elemente detektiert und/oder ausgelöst werden können, gemeinsam wirken.

Im Stand der Technik werden Antennen in der Regel auf einem Antennensubstrat bereitgestellt, welches bevorzugt einen Träger für eine Antenne darstellt. Für Antennensubstrate ist häufig eine möglichst niedrige Dielektrizitätszahl erstrebenswert, um die Konzentration der Feldlinien im Antennensubstrat zu reduzieren und damit die Ablösung der elektromagnetischen Signale zu erleichtern.

In Pozar (1996) wird ein Überblick über Antennen gegeben, die auf Substraten angebracht werden, insbesondere in Bezug auf Mikrostreifenantennen sowie aperturgekoppelten Substraten. Darin wird auch die Bedeutung der Bauweise des Substrates eingegangen, die Relevanz hat für die elektrischen und elektromagnetischen Eigenschaften der Antennen. So führt eine geringere relative Permittivität zu einer größeren Impedanzbandbreite und geringeren Oberflächenwellenanregung. Die Dicke des Substrates wirkt sich auf die Bandbreite und den Kopplungspegel aus. Ein dickeres Substrat ergibt eine größere Bandbreite, aber dafür eine geringere Kopplung für eine gegebene Apertur in dem Substrat.

In Kumar und Raghavan (2016) wird eine Bereitstellung von Antennen und Antennenarrays auf Basis der sogenannten SIW-Technologie (englisch: substrate-integrated waveguide) diskutiert. Die SIW-Technologie, die als Brücke zwischen planarer und nicht-planarer Technologie fungiert, eignet sich insbesondere für den Bereich von Mikro- und Millimeterwellen.

In der WO 2009/053460 A1 wird ein Verfahren zur Herstellung eines Radarsensors offenbart. Dazu wird zunächst eine keramische Trägerstruktur mit einem Verteilnetzwerk bereitgestellt, wobei an der keramischen Trägerstruktur Kavitäten ausgebildet sind. Die Kavitäten werden daraufhin mit einer Materialmatrix aus einem ersten Material mit Einschlüssen aus einem zweiten Material befüllt. Damit kann innerhalb der Materialmatrix eine Vielzahl von Bereichen mit niedrigeren Dielektrizitätszahlen als diejenigen des ersten Materials ausgebildet werden. Anschließend werden planare Patchantennen auf die Materialmatrix aufgetragen.

Im Stand der Technik gibt es auch Ansätze zur Bereitstellung von Vorrichtungen, die einen funktionalen Zusammenhang zwischen MEMS-Elementen und Antennen nutzen.

In der DE 102014214153 B4 wird eine Mikrofonanordnung offenbart umfassend ein oberflächenmontierbares Mikrofonpackage, welches mit einer Antenne im Kontext eines Mobiltelefons datenverbunden ist. Die Antenne kann dazu konfiguriert sein, Signale zu senden, die durch die Mikrofonanordnung ausgegeben werden.

In der DE 10 2016 125 722 A1 werden Antennen mit MEMS-basierten Winkelbeschleunigungsmesser kombiniert, wobei die Antennen als drahtlose Verbindung für eine E/A-Schnittstelle (Eingabe/Ausgabe) verwendet werden. Die Antennen und/oder geeignete Komponenten der drahtlosen E/A-Schnittstelle können auf einem Substrat, wie z. B. einem flexiblen Substrat, angeordnet sein.

In der US 2011/0100123 A1 wird ein Beschleunigungssensor offenbart, dessen Funktionsbetrieb auf einem thermischen Messprinzip beruht. Der Beschleunigungssensor weist ein flexibles Substrat auf, auf dem eine Basisschicht aufgebracht wird. Weiterhin liegt eine Kavität an einer Oberfläche der Basisschicht vor. Innerhalb der Kavität sind MEMS-Elemente angebracht, die durch zwei Temperatursensoren und einen Heizer gebildet werden können. Oberhalb der MEMS-Elemente liegt eine Abdeckung vor, welche luftdicht mittels eines Klebers aufgebracht wird. Ferner weist der Beschleunigungssensor eine RFID-Antenne auf, die auf dem flexiblen Substrat angeordnet ist. Mittels der RFID-Antenne wird es ermöglicht, Radiosignale zu versenden und zu empfangen, um die Performance der MEMS-Elemente zu optimieren.

Obwohl es im Stand der Technik Konzepte gibt, eine gemeinsame Wirkung von MEMS-Elementen und Antennen zu nutzen, liegen hinsichtlich der Kombination dieser Bauteile Nachteile vor. So resultieren häufig hohe elektromagnetische Verluste an Verbindungen, die MEMS-Elemente und Antennen aufweisen. Daher können elektromagnetische Signale nicht effizient genutzt werden. Auch der Herstellungsprozess als solcher weist Nachteile auf, da es beispielsweise zu Fehlern bei Fügeverfahren während der Einbringung der Komponenten kommen kann. Des Weiteren ist auch eine Flexibilität hinsichtlich der geometrischen Ausgestaltung von Trägern erschwert, welche MEMS-Elemente und Antennen aufweisen sollen.

So sind aufgrund der unterschiedlichen Erfordernisse von MEMS-Elementen und Antennen zumeist nur eingeschränkte Formen möglich.

Mithin besteht im Lichte des Standes der Technik ein Bedarf alternativer oder verbesserter Vorrichtungen und/oder Verfahren, die Antennen und MEMS-Elemente aufweisen und deren Wirkungsweisen kombinieren.

### Aufgabe der Erfindung

Aufgabe der Erfindung war es, die Nachteile des Standes der Technik zu beseitigen. Insbesondere sollte ein MEMS-Package bzw. ein Verfahren zu dessen Herstellung bereitgestellt werden, welche auf kompakte Weise MEMS-Elemente mit Antennen kombiniert, eine effiziente Funktionsweise und Schutz beider Komponenten gewährleistet und sich zudem vorzugsweise durch eine einfache, kostengünstige und Herstellung auszeichnet.

### Zusammenfassung der Erfindung

Die erfindungsgemäße Aufgabe wird gelöst durch die Merkmale der unabhängigen Ansprüche. Vorteilhafte Ausgestaltungen der erfindungsgemäßen Aspekte sind in den abhängigen Ansprüchen beschrieben.

Die Erfindung betrifft also ein MEMS-Package umfassend
a.ein Packagesubstrat,
b. mindestens ein MEMS-Element umfassend einen MEMS-Interaktionsbereich, wobei das mindestens eine MEMS-Element in dem Packagesubstrat mindestens teilweise eingebettet vorliegt, sodass mindestens der MEMS-Interaktionsbereich frei bleibt,
wobei dem Packagesubstrat eine oder mehrere Antennen zum Senden und/oder Empfangen von elektromagnetischen Signalen vorliegen, wobei das Packagesubstrat als Antennensubstrat für die eine oder mehreren Antennen fungiert, wobei das Packagesubstrat in dem MEMS-Package eine Gehäuse- und/oder Schutzfunktion für das mindestens eine MEMS-Element erfüllt und gleichzeitig eine Wirkverbindung mit einer Umgebung vorliegt, sodass das mindestens eine MEMS-Element ein Signal aus der Umgebung empfangen und/oder in die Umgebung versenden kann und das mindestens eine MEMS-Element und/oder die eine oder mehreren Antennen auf einem nicht-planaren Abschnitt vorliegt.

Im erfindungsgemäßen Kontext wurde erkannt, dass Anforderungen für eine oder mehrere Antennen sowie für mindestens ein MEMS-Element durch ein Packagesubstrat kombiniert werden können. Im Stand der Technik wurde von einer derart kombinierte Anbringung von MEMS-Elementen und Antennen abgesehen, da Packagematerialien und Antennensubstrate teilweise divergierende Eigenschaften erfüllen müssen. So weisen Packagingmaterialien für MEMS-Elemente häufig Metall auf (siehe z. B. Dehé et al. (2013)) und sind damit elektrisch leitfähig sind, um einen hinreichenden Schutz für das MEMS-Element zu bieten und gleichzeitig auch geeignete elektrische und mechanische Bedingungen für die Funktionstüchtigkeit des MEMS-Elementes zu ermöglichen. Auch können Keramiken oder Kunststoffe als Packagingmaterialien für MEMS-Elemente genutzt werden. Jedoch haben sich Keramiken als teuer erwiesen und Kunststoffe weisen eine gewisse Durchlässigkeit gegenüber Feuchtigkeit auf (siehe Stanimirović, 2014). Mithin ist man im Stand der Technik dazu geneigt, Metall und damit elektrisch leitfähiges Material als Packagingmaterial für MEMS-Elemente zu nutzen.

Antennen im Kontext der Mikrosystemtechnik werden allerdings typischerweise auf Substraten angebracht, die dielektrische Funktion erfüllen, bevorzugt eine niedrige relative Permittivität und damit eine niedrige Permittivität (Produkt aus elektrischer Feldkonstante ε₀ und relativer Permittivität εᵣ: ε = ε₀ εᵣ) aufweisen, um hinsichtlich des Verlaufs der elektrischen und magnetischen Feldlinien eine optimale Funktionstüchtigkeit der Antennen zu gewährleisten.

Die Erfinder haben erkannt, dass ein Packagesubstrat für mindestens ein MEMS-Element gleichzeitig als Antennensubstrat verwendet werden kann. In anderen Worten kann auch davon gesprochen werden, das Antennensubstrat als Packagesubstrat für ein MEMS-Element zu verwenden.

Das erfindungsgemäße MEMS-Package stellt daher eine Abkehr gegenüber dem Stand der Technik dar, indem zwei bisher als unterschiedlich angesehene Anforderungsprofile, nämlich das Packaging von MEMS-Elementen zur Erfüllung einer Gehäuse- und/oder Schutzfunktion und die Bereitstellung eines Antennensubstrates, miteinander kombiniert werden.

Das erfindungsgemäße MEMS-Package hat sich in vielen Aspekten als besonders vorteilhaft erwiesen.

Zum einen wird durch das bevorzugte MEMS-Package eine besonders kompakte Bauweise geboten. So liegen vorteilhaft mindestens ein MEMS-Element sowie eine oder mehrere Antennen auf und/oder in demselben Packagesubstrat vor. Insbesondere ist es mithin nicht notwendig, das mindestens eine MEMS-Element sowie die eine oder mehreren Antennen an unterschiedlichen Trägerstrukturen zu platzieren, was eine höhere räumliche Distanz und damit größere Abmessungen des gesamten Bauteils zur Folge hätte. Weiterhin wird vorteilhafterweise eine monolithische Integration von MEMS-Elementen und Antennen ermöglicht, sodass auch separate Fügungen der Bauteile nicht mehr benötigt werden. Insgesamt resultiert für das bevorzugte MEMS-Package eine komprimierte Bauweise, die sich für eine Vielzahl von Anwendungen eignet und dabei gleichzeitig sowohl eine Schutz- und/oder Gehäusefunktion für das mindestens eine MEMS-Element erfüllt als auch eine optimale Funktionsfähigkeit der einen oder mehreren Antennen ermöglicht.

Weiterhin ist es von Vorteil, dass durch die kompakte Ausgestaltung und Kommunikationsmöglichkeiten des MEMS-Packages eine effiziente Integrationsmöglichkeit geboten wird. Das bevorzugte MEMS-Package benötigt nur geringfügigen Stauraum, kann sich flexibel in unterschiedlichste geometrische Ausgestaltungen einfügen und erlaubt zudem über die bereitgestellten Antennen eine einfache kabellose Ansteuerung und/oder Datenaustausch. Zudem erlaubt das erfindungsgemäße MEMS-Package eine kombinierte Nutzung und/oder Verarbeitung verschiedener Signalarten. Damit ergeben sich vorteilhaft erweiterte Funktionsmöglichkeiten, da sowohl Funktionen von dem mindestens einen MEMS-Element sowie der einen oder mehreren Antennen in gemeinsamer Wirkung eingesetzt werden können. So können beispielsweise versendete und/oder empfangene elektromagnetische Signale auch für das mindestens eine MEMS-Element genutzt werden, und umgekehrt. Eine kombinierte Nutzung und/oder Verarbeitung verschiedener Signalarten führt beispielsweise zu Vorteilen im Hinblick auf eine gewünschte Verstärkung und/oder eine Richtwirkung von Signalen, wie z. B. für ein Beamforming.

Mittels Beamforming können im Allgemeinen Signale bzw. Strahlung eine Richtwirkung erhalten, sodass sie gezielter empfangen und/oder versendet werden können. Beamforming lässt sich insbesondere an elektromagnetischen Wellen anwenden. Hierbei erfolgt eine Bündelung oder Ausrichtung von elektromagnetischen Wellen durch einen Sender und/oder auf einen Empfänger mittels entsprechender Anordnungen von Antennen. Durch ein derartiges Beamforming, beispielsweise zur drahtlosen Kommunikation, kann die Reichweite erhöht, eine Übertragungsleistung gesteigert und stabilere Verbindungen ermöglicht werden. Ebenso kann ein Beamforming für akustische Signale (Schallwellen) eingesetzt werden, wodurch ein zielgerichtetes Empfangen und/oder Senden von Schallwellen ermöglicht wird.

Vorteilhaft erlaubt das erfindungsgemäße MEMS-Package auf kompakte Weise eine Integration sowohl einer Vielzahl von Antennen als auch von MEMS-Elementen, beispielsweise akustischer MEMS-Wandler in Form von Arrays. In bevorzugten Ausführungsformen kann das MEMS-Package somit auch für ein wechselseitiges und/oder kombiniertes Beamforming von elektromagnetischen und akustischen Signalen eingesetzt werden. Wie hierin noch ausführlicher erläutert wird, kann in dieser Hinsicht eine wechselseitige und/oder kombinierte Verarbeitung von akustischen und elektromagnetischen Signale besonders vorteilhaft sein, um eine verbesserte Lokalisierung und zielgenaueres Beamforming zu ermöglichen.

Neben den flexiblen Anwendungsmöglichkeiten zeichnet sich das MEMS-Package vorteilhaft durch eine besonders kosteneffiziente und flexible Herstellung aus, da bevorzugt Verfahren der additiven Fertigung (3D-Druck) eingesetzt werden können, um das Packagesubstrat nebst integrierter Komponenten bereitzustellen.

Insbesondere durch Verfahren der additiven Fertigung besteht eine hohe Flexibilität in Bezug auf mögliche geometrische Formen, um eine Platzierung von MEMS-Elementen und/oder Antennen im Hinblick auf bevorzugte Anwendung zu optimieren. Beispielsweise kann es für ein Beamforming bevorzugt sein, die Antennen und/oder MEMS-Elemente auf nicht-planaren, z. B. konkaven Abschnitten, anzuordnen, um eine stärkere Fokussierung zu ermöglichen. Ebenso kann es bevorzugt sein, die Antennen und/oder MEMS-Elemente auf einer Substratoberfläche mit konvexer Form anzuordnen, um Signale über einen größeren Winkelbereich zu empfangen und/oder zu senden. Weiterhin lässt sich vorteilhaft die Anzahl von MEMS-Elementen und/oder Antennen für das MEMS-Package auf einfache Weise skalieren, ohne dass ein erhöhter Integrationsaufwand nötig wäre.

Das MEMS-Package bzw. dessen bevorzugten Herstellung mittels einer additiven Fertigung erlaubt somit eine Anpassung bzw. Optimierung an verschiedenste Anwendungen.

Ein weiterer Vorteil stellt in dieser Hinsicht eine einfache Einbringung von Leiterbahnen für die Bereitstellung einer elektrischen Kontaktierung auf und/oder in dem Packagesubstrat dar, welche beispielsweise während einer multimateriellen additiven Fertigung in einem Prozessablauf zusammen mit dem Aufbau des Packagesubstrates aufgetragen werden können. In bevorzugten Ausführungsformen kann das MEMS-Package beispielsweise eine Recheneinheit aufweisen, um Signale des mindestens einen MEMS-Elements und/oder der einen oder mehreren Antennen zu verarbeiten. Eine Kontaktierung der Recheneinheit über Leiterbahnen mit entsprechenden Antennen und/oder MEMS-Elementen ist vorteilhaft besonders prozesseffizient möglich.

Mithin zeichnet sich das MEMS-Package durch eine Reihe von Vorteilen in Bezug auf die Konstruktion, Herstellung und Funktionsfähigkeit aus, sodass deutliche Verbesserungen gegenüber dem Stand der Technik erzielt werden konnten.

Ein MEMS-Package bezeichnet im Sinne der Erfindung bevorzugt eine Vorrichtung, die mindestens ein MEMS-Element aufweist, welches derart in einem Packagesubstrat eingebettet vorliegt, dass ein MEMS-Interaktionsbereich bevorzugt frei bleibt. Das Packagesubstrat in dem MEMS-Package erfüllt erfindungsgemäß eine Gehäuse- und/oder Schutzfunktion für das MEMS-Element, wobei gleichzeitig eine Wirkverbindung mit der Umgebung vorliegt, sodass das mindestens eine MEMS-Element ein Signal aus der Umgebung empfangen und/oder in die Umgebung versenden kann. Erfindungsgemäß ist vorgesehen, dass der MEMS-Interaktionsbereich des MEMS-Elementes frei bleibt. Das bevorzugte MEMS-Package weist mithin bevorzugt eine Bauweise auf, welche sicherstellt das MEMS-Element in dem Packagesubstrat mindestens teilweise verpackt bzw. umschlossen (und geschützt) ist, wobei gleichzeitig ein Interaktionsbereich frei bleibt, über welchen das MEMS-Element mit der Umgebung interagieren kann.

Das Packagesubstrat bezeichnet bevorzugt diejenige Komponente des MEMS-Packages, welche zur Einbettung des mindestens einen MEMS-Elementes dient. Vorzugsweise liegen auf oder in dem Packagesubstrat neben dem mindestens einen MEMS-Element eine oder mehrere Antennen vor. Das Packagesubstrat erfüllt bevorzugt die eigentliche Packagefunktion, d. h. eine Gehäuse -und/oder Schutzfunktion für das mindestens eine MEMS-Element. Vorteilhaft ist es somit nicht notwendig, eine separate Komponente anzubringen, die dem Schutz des mindestens einen MEMS-Elementes gewidmet ist, beispielsweise in Form einer Abdeckung. Im Stand der Technik, wie der US 2011/0100123 A1, ist stattdessen eine Anbringung derartigen Abdeckung für den Schutz von MEMS-Elementen vorgesehen. Erfindungsgemäß kann stattdessen das Packagesubstrat selbst einen zuverlässigen Schutz für das mindestens eine MEMS-Element bietet. Vorzugsweise ist der MEMS-Interaktionsbereich des mindestens einen MEMS-Elementes im erfindungsgemäßen Kontext weiterhin frei, sodass ein Austausch mit der Umgebung möglich ist. Dies ist durch die Anbringung der Abdeckung über den MEMS-Elementen in der US 2011/0100123 A1 nicht oder nur eingeschränkt gegeben, da die Abdeckung einen Austausch mit der Umgebung verhindert. Vorteilhaft kann stattdessen das Packagesubstrat eine Gehäuse- oder Schutzfunktion für das MEMS-Element erfüllen, während das MEMS-Element über den freibleibenden Interaktionsbereich ein Signal aus der Umgebung empfangen und/oder in die Umgebung versenden kann.

Gleichzeitig fungiert das Packagesubstrat bevorzugt als Antennensubstrat für eine oder mehrere Antennen. Das Antennensubstrat bezeichnet bevorzugt einen Träger für eine oder mehrere Antennen Somit können eine oder mehrere Antenne auf oder in dem Antennensubstrat angebracht werden. Antennensubstrate sollten je nach Anwendungszweck bestimmte dielektrische Eigenschaften erfüllen, da beispielsweise die Verwendung eines Materials für das Antennensubstrat mit einer hohen relativen Permittivität allgemein den Abstrahlwirkungsgrad der einen oder mehreren Antennen verringert. Erfindungsgemäß wurde erkannt, dass ein Antennensubstrat gleichzeitig als Packagesubstrat für mindestens ein MEMS-Element verwendet werden kann oder umgekehrt.

In bevorzugten Ausführungsformen ist das Packagesubstrat monolithisch, d. h. es ist einstückig, zusammenhängend und/oder fugenlos aufgebaut. Im erfindungsgemäßen Kontext ist das Packagesubstrat einerseits auf die Anbringung des mindestens einen MEMS-Elementes gerichtet. Ferner fungiert das Packagesubstrat gleichzeitig als Antennensubstrat. Mit anderen Worten ausgedrückt liegt das mindestens eine MEMS-Element und die eine oder mehreren Antennen bevorzugt innerhalb bzw. auf ein und demselben Packagesubstrat bzw. Antennensubstrat vor. Hierbei ist vorzugsweise sowohl eine mindestens teilweise Einbettung des MEMS-Elementes in das Packagesubstrat (bzw. Antennensubstrat), als auch eine Anbringung der einen oder mehreren Antennen auf dem Antennensubstrat (bzw. Packagesubstrat), unmittelbar bzw. direkt (ohne Zwischenschicht) vorgesehen.

In dieser Hinsicht unterscheidet sich das erfindungsgemäße MEMS-Package strukturell weiter von bekannten Anordnungen des Standes der Technik, wie beispielsweise in der US 2011/0100123 A1 gelehrt. Darin wird offenbart, die MEMS-Elemente auf einer Basisschicht anzubringen, welche auf einem Substrat vorliegt. Die dortig eingesetzten RFID-Antennen werden hingegen auf dem Substrat angeordnet. Somit liegen die MEMS-Elemente und die RFID-Antennen in bzw. an unterschiedlichen Komponenten vor, nämlich die MEMS-Elemente in oder auf einer Basisschicht (welche sich auf einem Substrat befindet) und die RFID-Antennen auf dem Substrat. Entgegen der erfindungsgemäßen Lehre fungiert das Antennensubstrat der US 2011/0100123 A1 mithin nicht als Packagesubstrat für die MEMS-Elemente.

Dabei entspricht bevorzugt das Packagesubstrat nicht dem Trägersubstrat eines MEMS-Elementes. Das Trägersubtrat eines MEMS-Elementes - beispielsweise ein Halbleitersubstrat - bezeichnet bevorzugt eine Komponente des MEMS-Elementes, auf die funktionsrelevante Komponenten des MEMS-Elementes, wie z. B. MEMS-Strukturen, elektronische Schaltungen etc. angebracht sind. Erfindungsgemäß liegt das mindestens eine MEMS-Element mitsamt des Trägersubstrates in dem Packagesubstrat mindestens teilweise eingebettet vor.

Eine mindestens teilweise Einbettung des MEMS-Elementes in dem Packagesubstrat meint bevorzugt, dass mindestens ein Abschnitt des MEMS-Elementes vom Packagesubstrat umschlossen wird. Dabei kann bevorzugt ein Anteil des MEMS-Elementes, bevorzugt das MEMS-Element im Wesentlichen, vom Packagesubstrat umschlossen werden, sodass das MEMS-Element mindestens teilweise innerhalb des Packagesubstrates integriert ist. Ein im Wesentlichen vom Packagesubstrat umschlossenes MEMS-Element weist vorzugsweise mit dem Packagesubstrat zumindest teilweise (insbesondere in Bereichen außerhalb des Interaktionsbereiches) einen formschlüssigen Materialkontakt auf. Hierdurch kann im Sinne eines Einbettens eine Schutzfunktion durch das Packagesubstrat bereitgestellt werden, in dem das Eindringen bzw. Passieren von Flüssigkeiten oder Schmutz durch den Materialkontakt zwischen Packagesubstrat und MEMS-Element verhindert wird. In bevorzugten Ausführungsformen weist das MEMS-Element entlang einer Umrandung einen durchgängigen Materialkontakt mit dem Packagesubstrat auf, welcher als eine Dichtekante fungiert und einen hermetischen Abschluss bereitstellen kann. Bevorzugt ist das MEMS-Element innerhalb des Packagesubstrates jedoch derart mindestens teilweise eingebettet, dass ein MEMS-Interaktionsbereiches frei bleibt. Mithin wird das MEMS-Element durch die mindestens teilweise Einbettung des Packagesubstrates geschützt und gleichzeitig eine Verbindung mit der Umgebung ermöglicht, sodass Signale aus der und/oder in die Umgebung vom MEMS-Element empfangen und/oder versendet werden können.

Dass der MEMS-Interaktionsbereich frei bleibt meint bevorzugt, dass eine Interaktion mit der Umgebung und/oder einem Medium möglich ist. Das Freibleiben bezieht sich bevorzugt auf die Interaktionsmöglichkeit des MEMS-Elemente und kann in Vorzugsformen ein Ausbleiben des Packagesubstrates im Interaktionsbereich meinen, ebenso kann es auch bevorzugt sein, dass das Packagesubstrat im Interaktionsbereich mit einer hinreichenden geringen Schichtdicke vorliegt, sodass eine Funktionsfähigkeit des MEMS-Elementes in Bezug auf eine Interaktion nicht wesentlich gestört wird. Ein Freibleiben kann beispielsweise für einen akustischen MEMS-Wandler durch eine Aussparung in Form einer Öffnung im Packagesubstrat oberhalb einer schwingfähigen Membran erfüllt werden. Ebenso kann das Freibleiben des MEMS-Interaktionsbereiches bevorzugt durch einen transparenten Bereich geboten werden, beispielsweise für einen optischen MEMS-Sensor oder einen MEMS-Gassensor.

Bevorzugt ist der MEMS-Interaktionsbereich ein wesentlicher funktioneller Bestandteil des MEMS-Elements, welcher vorzugsweise mit einem Medium und/oder der Umgebung in gewünschter Weise interagiert. Daher ist es bevorzugt, dass der MEMS-Interaktionsbereich freibleibt, um hierdurch eine Interaktion mit einem Medium und/oder einer Umgebung des MEMS-Packages vornehmen zu können. Die konkrete Ausgestaltung des MEMS-Interaktionsbereiches hängt vom jeweiligen MEMS-Element ab.

Im Falle eines akustischen MEMS-Wandlers kann es sich beispielsweise um eine MEMS-Membran handeln. Im Falle eines optischen MEMS-Wandlers kann es sich beispielsweise um einen optischen Emitter handeln. In beiden Fällen ist es bevorzugt, dass unmittelbar im Interaktionsbereich des MEMS-Elementes kein Packagesubstrat die Interaktion des MEMS-Elementes mit der Umgebung (Schallabgabe oder -aufnahme, Senden bzw. Empfangen optischer Signale) vermindert, während der Schutz der empfindlichen elektronischen Komponenten durch die Einbettung des MEMS-Elementes in anderen Bereichen gewährleistet wird.

Erfindungsgemäß liegen eine oder mehrere Antennen auf oder in dem Packagesubstrat vor. Eine Antenne bezeichnet eine Vorrichtung zum Senden und/oder Empfangen von elektromagnetischen Signalen.

Im Sinne der Erfindung umfasst ein elektromagnetisches Signal bevorzugt eine elektromagnetische Welle. Der durchschnittliche Fachmann weiß, dass im erfindungsgemäßen Kontext die Begriffe "elektromagnetisches Signal" und "elektromagnetische Welle" synonym verwendet werden können.

In einer bevorzugten Ausführungsform ist das MEMS-Package dadurch gekennzeichnet, dass das Packagesubstrat ein dielektrisches Material umfasst, wobei bevorzugt das dielektrische Material ausgewählt ist aus einer Gruppe umfassend Niedertemperatur-Einbrand-Keramik (LTCC) und/oder Hochtemperatur-Mehrlagenkeramik (HTCC).

In weiteren bevorzugten Ausführungsformen umfasst das Antennensubstrat ein Material ausgewählt aus einer Gruppe umfassend Polyimid, Epoxid, Harz und/oder Epoxidarz.

Die genannten Materialien haben als besonders vorteilhaft erwiesen, um als Antennensubstrat die gewünschten dielektrischen Eigenschaften zu erfüllen. Erfindungsgemäß wurde erkannt, dass diese Materialien, insbesondere LTCC, gleichzeitig einen optimalen Schutz vor Einflüssen aus der Umgebung für das mindestens eine MEMS-Element bieten. Zudem eignen sich die genannten Materialien für Verfahren der additiven Fertigung. Insbesondere können die genannten Materialien im Rahmen der Bereitstellung des Packagesubstrates effizient geformt werden, um je nach Anwendungsfall beispielsweise planare und/oder nicht-planare Abschnitte bereitzustellen.

In Bezug auf eine kombinierte Verwendung als Packagingmaterial für das mindestens eine MEMS-Element und als Antennensubstrat hat sich insbesondere LTCC als überaus vorteilhaft erwiesen. Zum einen weist LTCC vorzugsweise eine geeignete, vergleichsweise hohe, relative Permittivität auf, die für die Aufnahme von elektronischen Bauelementen in Hochfrequenzschaltungen vorteilhaft ist. Des Weiteren isoliert diese hohe relative Permittivität hochfrequente elektromagnetische Felder in Leiterbahnen, Durchkontaktierungen und/oder Drahtbonds und verhindert vorteilhaft ein Übersprechen. Gleichzeitig lässt sich LTCC vorteilhaft für ein Packaging von MEMS-Elementen einsetzen, wobei ein hoher Schutz des Bauteils vor Staub, Feuchte, Flüssigkeiten und elektrostatischen Entladungen erreicht wird, ohne dass es zu Einbußen funktioneller Eigenschaften kommt.

In einer bevorzugten Ausführungsform ist das MEMS-Package dadurch gekennzeichnet, dass das Packagesubstrat ein dielektrisches Material umfasst, wobei das Material eine relative Permittivität εᵣ von größer 1 aufweist, bevorzugt zwischen 1 - 10, besonders bevorzugt zwischen 2 - 8, ganz besonders bevorzugt zwischen 5 - 10.

Bevorzugt weist das Antennensubstrat eine niedrige relative Permittivität auf, besonders bevorzugt in den Bereichen, in denen die eine oder mehreren Antennen vorliegen. Durch eine verhältnismäßig geringe relative Permittivität verringert sich die Konzentration der elektromagnetischen Feldlinien im Packagesubtrat bzw. Antennensubstrat, was für eine Aussendung und/oder einen Empfang der elektromagnetischen Signale vorteilhaft ist.

Bevorzugt sind auf oder in dem Packagesubstrat auch elektronische Komponenten angebracht, wie z. B. elektronische Schaltungen, Recheneinheiten, Verteilernetzwerke zur Steuerung der einen oder mehreren Antennen und/oder um ihre Wirkungsweise zu regulieren. Im Bereich von elektronischen Komponenten, insbesondere für die Steuerung der einen oder mehreren Antennen, ist eine verhältnismäßig hohe relative Permittivität vorteilhaft, da hochfrequente elektromagnetische Felder isoliert werden und damit auch Abstrahlungen ausgehend von elektronischen Komponenten verringert werden können.

In bevorzugten Ausführungsformen weist das Packagesubstrat Bereiche auf, die unterschiedliche relative Permittivitäten aufweisen, wobei bevorzugt ein Abschnitt für Antennen vorzugsweise niedrige relative Permittivitäten aufweist und ein Abschnitt für die Anbringung von elektronischen Schaltungen vorzugsweise hohe relative Permittivitäten aufweist.

Beispielsweise weist LTCC eine vergleichsweise hohe relative Permittivität auf (ca. 7 - 8) und ist im Bereich von elektronischen Schaltungen, insbesondere zur Steuerung der Antennen, vorteilhaft. Ein Beispiel für eine Materialgruppe mit einer verhältnismäßig geringen relativen Permittivität bilden Polyimide, die eine relative Permittivität zwischen ca. 3 - 3,5 haben. Eher geringe relative Permitivitäten liegen im Kontext der Erfindung zwischen ca. 1 - 5, während eher hohe Permittivitäten in einem Bereich ab ca. 5 liegen.

Damit kann bevorzugt das Packagesubstrat vorzugsweise auch mehrere Materialien umfassen. Ebenfalls kann es bevorzugt sein, dass das Packagesubstrat im Wesentlichen durch ein Material gebildet wird. In bevorzugten Ausführungsformen ist das Packagesubstrat monolithisches ausgeführt, wobei der Begriff monolithisch insbesondere meint, dass keine separate Herstellung und anschließende Fügung von Bestandteilen des Packagesubstrates (beispielsweise für ein Packaging der MEMS-Elemente und/oder als Substrat der Antenennen) notwendig ist.

Für eine Verringerung der relativen Permittivität kann es auch bevorzugt sein, das Material des Packagesubstrates porös auszugestalten. Durch Poren wird die Materialdichte und damit auch die Dipoldichte durch die Bereitstellung von freiem Volumen verringert und damit auch die relative Permittivität.

In einer weiteren bevorzugten Ausführungsform ist das MEMS-Package dadurch gekennzeichnet, dass das MEMS-Package eine Recheneinheit aufweist, welche vorzugsweise auf oder in dem Packagesubstrat vorliegt.

Eine Recheneinheit bezeichnet im Sinne der Erfindung bevorzugt eine Datenverarbeitungseinheit, d. h. eine Einrichtung die vorzugsweise dazu in der Lage ist, konfiguriert zu werden, um Daten zu verarbeiten. Die Recheneinheit kann bevorzugt ausgewählt sein aus einer Gruppe umfassend eine integrierte Schaltung (IC), eine anwendungsspezifische integrierte Schaltung (ASIC), eine programmierbare logische Schaltung (PLD), ein Field Programmable Gate Array (FPGA), einen Prozessor, einen Mikroprozessor, einen Mikrocomputer, eine speicherprogrammierbare Steuerung und/oder eine sonstige elektronische und/oder programmierbare Schaltung. Die Recheneinheit kann insbesondere selbst ein Prozessor oder eine Prozesseinheit sein oder von mehreren Prozessoren gebildet werden, bevorzugt um Daten zu verarbeiten.

Zur Verarbeitung von Daten ist es bevorzugt, dass auf der Recheneinheit eine Software installiert vorliegt, welche dazu eingerichtet ist bzw. Befehle umfasst, um entsprechende Verarbeitungsschritte ausführen zu können.

Der Begriff der Verarbeitung ist vorzugsweise breit auszulegen und umfasst vorzugsweise Rechenschritte, die nötig sind, um beispielsweise versendete und/oder empfangen Signale des MEMS-Elementes und/oder elektromagnetische Signale der einen oder mehreren Antennen für Anwendungszwecke zu nutzen, beispielsweise für ein Beamforming, eine Lokalisation, eine Ansteuerung etc.

In bevorzugten Ausführungsformen liegt die Recheneinheit in Kombination mit einer Kommunikationseinheit vor. In weiteren bevorzugten Ausführungsformen ist die Recheneinheit eine Kommunikationseinheit. In weiteren bevorzugten Ausführungsformen kann die Kommunikationseinheit durch die eine oder mehreren Antennen bereitgestellt werden. Vorzugsweise kann die Kommunikationseinheit die Daten in Form von elektromagnetischen Signale übermitteln, beispielsweise an eine weitere Datenverarbeitungseinheit.

In einer weiteren bevorzugten Ausführungsform ist das MEMS-Package dadurch gekennzeichnet, dass die eine oder mehreren Antennen als Patchantennen vorliegen.

Im Sinne der Erfindung bezeichnet eine Patchantenne eine Antenne, die eine Fläche umfassend ein leitfähiges Material umfasst. Vorzugsweise zeichnet sich die Patchantenne dadurch aus, dass die Länge und/oder die Breite der Fläche der Patchantenne um ein Vielfaches höher ist als die Dicke. In bevorzugten Ausführungsformen ist die Länge und/oder Breite der Fläche der Patchantenne um einen Faktor von ca. 2, bevorzugt ca. 5, 10, 20 oder mehr höher als die Dicke. Bevorzugt ist die Patchantenne im Wesentlichen flach ausgebildet, sodass sie sich vorteilhaft in geeigneter Weise auf oder in das Packagesubstrat auf- oder einbringen lässt.

In bevorzugten Ausführungsformen liegt die bevorzugte Patchantenne als ein Streifen vor umfassend ein leitfähiges Material, z. B. ein Metall (bspw. Kupfer) vor. Ein Streifen als Patchantenne ist bevorzugt dadurch gekennzeichnet, dass die Länge um ein Vielfaches höher ist als die Breite (beispielsweise um einen Faktor von ca. 2, bevorzugt ca. 5, 10 oder mehr),

In weiteren bevorzugten Ausführungsformen weist die Patchantenne eine polygone, bevorzugt eine rechteckige, eine dreieckige und/oder eine runde Form auf. In bevorzugten Ausführungsform weist die Patchantenne eine Länge auf, die ca. einer halben Wellenlänge eines elektromagnetischen Signales entspricht für dessen Senden oder Empfangen die Patchantenne ausgelegt ist.

Vorteilhafterweise eignen sich Patchantennen für das bevorzugte MEMS-Package besonders, da sie mit hoher Genauigkeit auf und/oder dem Packagesubstrat angefertigt werden können. So können Sie mit bekannten Ätz- und/oder Beschichtungsverfahren der Halbleiter- und Mikrosystemtechnik angebracht werden, die sich im Stand der Technik als prozesseffizient, einfach in der Ausführung und tauglich für eine Massenanfertigung etabliert haben. Somit sind Patchantennen vorteilhafterweise mit hoher Leichtigkeit auf oder in dem Packagesubstrat integrierbar. Auch die bevorzugt geringen Abmessungen der Patchantennen begünstigen vorteilhaft die Platzierung auf oder in dem Packagesubstrat.

Weiterhin eignen sich vorteilhafterweise Patchantennen für die Anbringung auf oder in dem Packagesubstrat dahingehend, dass eine Mehrzahl von Patchantennen als Antennenarray eine besonders gute Richtwirkungen erzielen kann. Vorteilhafterweise kann mittels einer Vielzahl von Patchantennen als Antennenarray ein kompliziert geformtes Antennendiagramm (graphische Darstellung der Strahlungscharakteristik der einen oder mehreren Antennen bzw. des Antennenarrays) erzeugt werden, dass mit einer Einzelantenne andernfalls schwierig zu realisieren wäre. Durch eine bevorzugte Anbringung eines Phasenverschiebers können beispielsweise empfangene und/oder versendete elektromagnetische Signale phasenverschoben und damit Effekte hinsichtlich einer Richtwirkung und/oder Intensitätserhöhung auf einfache und effiziente Weise genutzt werden, z. B. für ein Beamforming.

In weiteren bevorzugten Ausführungsformen können auch andere Typen von Antennen eingesetzt werden.

Der durchschnittliche Fachmann weiß, dass durch die Art und/oder die Form der einen oder mehreren Antennen Einfluss auf die Wellenlänge bzw. die Frequenz der elektromagnetischen Signale genommen werden kann. So kann in bevorzugten Ausführungsformen die ein oder mehreren Antennen elektromagnetische Signale senden und/oder empfangen in einem Frequenzbereichen zwischen ca. 3 - 30 Hz, 30 - 300 Hz, 0,3 - 3 kHz, 3 - 30 kHz, 30 - 300 kHz, 0,3 - 3 MHz, 3 - 30 MHz, 30 - 300 MHz, 0,3-3 GHz, 3 - 30 GHz, 30 - 300 GHz, 0,3-385 THz 0,3 - 20 THz, 20 - 37,5 THz, 37,5 - 100 THz, 100 - 214 THz, 100 - 385 THz und/oder 385 - 750 THz. Somit können eine Vielzahl von Frequenzbändern genutzt zum Versenden und/oder Empfangen von elektromagnetischen Signalen durch eine entsprechende Ausgestaltung der einen oder mehreren Antennen.

In einer weiteren bevorzugten Ausführungsform ist das MEMS-Package dadurch gekennzeichnet, dass das MEMS-Package mehrere Antennen in Form eines Antennenarrays aufweist, wobei bevorzugt das Antennenarray mindestens 2, 3, 4, 5, 6, 7, 8, 9, 10, 20, 50, 100 oder 500 oder mehr Antennen umfasst.

Mithilfe eines Antennenarrays wird es vorteilhaft ermöglicht, das Empfangen und/oder Versenden von elektromagnetischen Signalen durch Phasenverschiebung und/oder Interferenzeffekten zu verstärken und/oder zu intensivieren. Weiterhin können vorteilhaft durch den Einsatz von Antennenarrays Effekte wie das Beamforming für elektromagnetische Signale eingesetzt werden. Dabei hat sich die Anbringung eines Antennenarrays auf oder in dem Packagesubstrat als besonders nützlich erwiesen, da eine kompakte Ausgestaltung eines Antennenarrays durch das Packagesubstrat bereitgestellt werden kann. Vorteilhafterweise eignen sich die bevorzugten Patchantennen besonders gut, um ein Antennenarray auf oder in dem Packagesubstrat auszubilden. Darüber hinaus ist eine Arrayausgestaltung von Antennen dahingehend von Vorteil, dass hinsichtlich des Empfangs und/oder des Versendens von elektromagnetischen Signalen eine Redundanz gegeben ist, sodass selbst bei einem Ausfall einer Antenne kann weiterhin das Empfangen und/oder Versenden von elektromagnetischen Signalen ermöglicht werden. Vorteilhaft ist somit sowohl eine verbesserte Leistung als auch eine besonders hohe Zuverlässigkeit gegeben.

In bevorzugten Ausführungsformen weist das bevorzugte MEMS-Package Ausmaße zwischen ca. 0,1 cm - 10 cm, bevorzugt zwischen ca. 0,5 cm - 2 cm auf. Vorzugsweise umfassen die Ausmaße eine Länge, Höhe und/oder Breite des bevorzugten MEMS-Packages. So kann bevorzugt das MEMS-Package eine Länge und/oder Breite zwischen ca. 0,1 cm - 10 cm aufweisen, bevorzugt zwischen ca. 0,1 cm und 5 cm, besonders bevorzugt zwischen 0,1 cm - 2 cm. Vorzugsweise ist die Dicke des MEMS-Package (Dimension in Richtung des Empfangs und/oder Sendens von Signalen) geringer als eine Länge und/oder Breite ausgeführt und kann beispielsweise zwischen ca. 0 cm - 2 cm, bevorzugt zwischen ca. 0,1 cm - 1 cm, besonders bevorzugt zwischen ca. 0,1 cm - 0,5 cm betragen.

Der englische Begriff "Array" bedeutet bevorzugt "Anordnung, Aufstellung, Feld, Matrix". Ein Antennenarray bezeichnet im Sinne der Erfindung somit bevorzugt eine Anordnung aus mehreren, mindestens zwei, Antennen. Mithilfe eines Antennenarrays kann die Ausrichtung der empfangenen und/oder versendeten elektromagnetischen Signale bestimmt werden.

Die Geometrie des Antennenarrays bestimmt vorzugsweise, welche Ausrichtungen der elektromagnetischen Signale ermöglicht werden. Es gibt lineare Anordnungen, bei denen alle Antennen entlang einer Geraden angeordnet sind. Dies ist auch unter dem Ausdruck Uniform Linear Array (ULA) bekannt. Vorzugsweise können auch rechtwinklige Antennenarrays zum Einsatz kommen, die auch als Uniform Rectangular Array (URA) bezeichnet werden. Das URA ist dabei entlang einer Ebene angeordnet, z. B. entlang der x-y-Ebene, der y-z-Ebene oder der x-z-Ebene. Es können auch dreidimensionale Antennenarrays bevorzugt zum Einsatz kommen, wobei diese vorzugsweise von mehreren URAs, also von mehreren Ebenen, gebildet werden. Es kann auch bevorzugt sein, dass das Antennenarray entlang eines Kreises angeordnet ist, was auch unter dem Begriff Uniform Circular Array (UCA) bekannt ist. Es kann ebenfalls bevorzugt sein, dass Mischformen dieser Antennenarrys ausgebildet werden.

Ein eindimensionales Array entlang einer linearen Geraden weist bevorzugt eine zylindersymmetrische Charakteristik auf. Ihre Sensitivität unterscheidet lediglich Signaleinfallsrichtungen aus unterschiedlichen Winkeln zur Arrayachse. Ein solches Array unterscheidet nicht zwischen Signalen, die aus zueinander um die Arrayachse rotierenden Richtungen kommen.

Ein zweidimensionales Array, d. h. ein Array ausgebildet entlang einer Ebene, kann bevorzugt prinzipiell in alle Richtungen innerhalb des von der Array-Ebene begrenzten Halbraumes ausgerichtet werden. Allerdings unterscheiden zweidimensionale Arrays zumeist nicht zwischen Richtungen, die zueinander gespiegelt an der Array-Ebene liegen. Damit sind zweidimensionale Arrays "vorne-hinten-blind".

Dreidimensionale Arrays erlauben prinzipiell die Ausrichtung aus beliebige Raumrichtungen. "Vorne-hinten-Blindheit" und Abhängigkeit gegen Rotation werden bei dreidimensionalen Arrays vorteilhaft vermieden.

Vorteilhaft können die verschiedenen Arrayausgestaltungen in dem erfindungsgemäßen MEMS-Package auf einfache Weise realisiert werden.

In einer weiteren bevorzugten Ausführungsform ist das MEMS-Package dadurch gekennzeichnet, dass das mindestens eine MEMS-Element ausgewählt ist aus einer Gruppe umfassend einen MEMS-Wandler, bevorzugt ein MEMS-Mikrofon oder ein MEMS-Lautsprecher, und/oder ein MEMS-Sensor, bevorzugt ein MEMS-Flusssensor oder ein MEMS-Gassensor.

Vorteilhaft kann das Packagesubstrat eine Vielzahl von MEMS-Elementen aufweisen, sodass es sich für unterschiedlichste Anwendungen eignet.

Ein MEMS-Element bezeichnet im Sinne der Erfindung bevorzugt ein MEMS-Bauteil, d. h. ein Bauteil, dass mit den Methoden der MEMS-Technologie hergestellt wurde und/oder Abmessungen aufweist, die ca. im Mikrometerbereich vorliegen.

Unter dem Begriff MEMS-Wandler (auch akustischer MEMS-Wandler) ist vorzugsweise sowohl ein MEMS-Mikrofon als auch ein MEMS-Lautsprecher zu verstehen. Allgemein bezeichnet der MEMS-Wandler bevorzugt einen Wandler zur Interaktion mit einem Volumenstrom eines Fluids, bevorzugt in einer Umgebung des MEMS-Packages, der auf MEMS-Technologie basiert und dessen Strukturen zur Interaktion mit dem Volumenstrom bzw. zur Aufnahme oder Erzeugung von Druckwellen des Fluids eine Dimensionierung im Mikrometerbereich (1 pm bis 1000 pm) aufweisen. Bei dem Fluid kann es sich sowohl um ein gasförmiges als auch flüssiges Fluid handeln. Die Strukturen des MEMS-Wandlers, insbesondere der schwingfähigen Membran sind zur Erzeugung oder Aufnahme von Druckwellen des Fluids ausgelegt.

Beispielsweise kann es sich, wie im Falle eines MEMS-Lautsprechers oder MEMS-Mikrofons, um Schalldruckwellen handeln. Der MEMS-Wandler kann sich aber ebenso als Aktuator oder Sensor für andere Druckwellen eignen. Der MEMS-Wandler ist somit bevorzugt ein Gerät, welches Druckwellen (z. B. akustische Signale als Schallwechseldrücke) in elektrische Signale umwandelt oder umgekehrt (Umwandlung elektrischer Signale in Druckwellen, beispielsweise akustische Signale). Der MEMS-Interaktionsbereich ist beim MEMS-Wandler bevorzugt eine schwingfähige Membran.

MEMS-Wandler umfassen bevorzugt einen MEMS-Baustein (z. B. MEMS-Chip) mit einer schwingfähigen Membran, dessen Schwingungen beispielsweise durch piezoelektrische oder piezoresistive Komponenten auf bzw. an der Membran erzeugt und/oder ausgelesen werden.

In einer bevorzugten Ausführungsform ist der MEMS-Wandler ein piezoelektrischer MEMS-Wandler. Ebenso sind kapazitive Methoden zur Erzeugung und/oder Messung von Schwingungen der Membran bekannt. In einer bevorzugten Ausführungsform ist der MEMS-Wandler ein kapazitiver MEMS-Wandler.

In bevorzugten Ausführungsformen können MEMS-Wandler auch als MEMS-UltraschallTransducer ausgestaltet sein, welche zur Aussendung und/oder zum Empfang von Ultraschall geeignet sind. Dabei handelt es sich insbesondere um kapazitive mikromechanische Ultraschalltransducer (CMUT), um piezoelektrische mikromechanische Ultraschalltransducer (PMUT) oder um kombinierte Ultraschallransducer (piecoelectric composite ultrasound transducers, PC-MUT).

In einer weiteren bevorzugten Ausführungsform ist das MEMS-Element ein MEMS-Gassensor, wobei der MEMS-Interaktionsbereich eine MEMS-Membran und/oder einen elektrochemischen MEMS-Sensorbereich umfasst.

Beispielsweise kann es sich um ein photoakustisches Spektroskop mit einem MEMS-Sensor handeln. Bei der photoakustischen Spektroskopie wird bevorzugt eine intensitätsmodulierte Infrarotstrahlung mit Frequenzen im Absorptionsspektrum eines in einem Gas zu detektierendem Molekül eingesetzt. Ist dieses Molekül im Strahlengang vorhanden, findet eine modulierte Absorption statt, die zu Erwärmungs- und Abkühlungsprozessen führt, deren Zeitskalen die Modulationsfrequenz der Strahlung widerspiegeln. Die Erwärmungs- und Abkühlungsprozesse führen zu Expansionen und Kontraktion des Gases, wodurch Schallwellen mit der Modulationsfrequenz verursacht werden. Diese lassen sich durch Sensoren wie beispielsweise Schalldetektoren oder Flusssensoren messen.

Die Leistung der Schallwellen ist dabei vorzugsweise direkt proportional zur Konzentration des absorbierenden Gases. Ein photoakustisches Spektroskop umfasst daher bevorzugt einen mindestens einen Emitter, einen Detektor und eine Zelle. Bei einem MEMS-Gassensor wird bevorzugt der Detektor als MEMS-Sensor ausgeführt.

Ein MEMS-Sensor kann beispielsweise ein kapazitiv oder optisch auslesbaren, piezoelektrischen, piezoresistiven und/oder magnetischen Balken und/oder ein kapazitives, piezoelektrischen, piezoresistives und/oder optisches Mikrofon bzw. Membran umfassen.

In weiteren bevorzugten Ausführungsformen ist der MEMS-Sensor ein MEMS-Flusssensor. Ein MEMS-Flusssensor bezeichnet einen MEMS-Sensor zur Messung eines Flusses eines Fluides. Dazu kann beispielsweise der Volumendurchfluss und/oder der Massendurchfluss des Fluids gemessen werden ausgehend von dem MEMS-Flusssensor.

Im Sinne der Erfindung ist der Bereich eines MEMS-Sensor, welcher mit der Umgebung beispielsweise einem Medium interagiert, bevorzugt als dessen MEMS-Interaktionsbereich aufzufassen.

In einer weiteren bevorzugten Ausführungsform ist das MEMS-Element ein MEMS-Filter, bevorzugt ein MEMS-Frequenzfilter, insbesondere ein SAW- oder BAW-Filter, wobei der MEMS-Interaktionsbereich eine MEMS-Filterstruktur, insbesondere MEMS-Elektroden und/oder einen MEMS-Bulkbereich umfasst.

Ein SAW-Filter ist bevorzugt ein akustischer-Oberflächenwellen-Filter, (ebenso AOW-Filter), welcher insbesondere einen Bandpassfilter für elektrische Signale darstellt. Diese basieren vorzugsweise auf Interferenz von Signalen verschiedener Laufzeit und verwenden bevorzugt den Piezoeffekt. Bevorzugt ist auf einem piezoelektrischen Einkristall je ein Paar kammförmig ineinandergreifender Elektroden umfasst, welche vorzugsweise den Interaktionsbereich bilden.

BAW-Filter (engl. bulk acoustic wave) sind vorzugsweise ähnliche elektronische Filter mit Bandpass-Charakteristik. Jedoch weisen diese bevorzugt im Gegensatz zum SAW-Filter ein Substrat (Bulk) auf, indem die Ausbreitung der akustischen Wellen erfolgt. Dieses Substrat bzw. dieser Bulkbereich bildet vorzugsweise den MEMS-Interaktionsbereich.

In einer weiteren bevorzugten Ausführungsform ist das MEMS-Package dadurch gekennzeichnet, dass in dem Packagesubstrat mindestens teilweise ein MEMS-Element-Array umfassend mehrere MEMS-Elemente eingebettet vorliegt, wobei bevorzugt das MEMS-Element-Array mindestens 2, 3, 4, 5, 6, 7, 8, 9, 10, 20, 50, 100 oder 500 oder mehr MEMS-Elemente umfasst und/oder wobei bevorzugt das MEMS-Element-Array ein MEMS-Mikrofon-Array und/oder ein MEMS-Lautsprecher-Array umfasst.

Analog zum Antennenarray kann vorteilhaft ein MEMS-Element-Array, welches bevorzugt mindestens teilweise eingebettet in dem Packasubstrat vorliegt, zur Verstärkung des Signals beitragen, welches mittels eines MEMS-Elements empfangen und/oder versendet werden kann. Des Weiteren ist eine besonders zuverlässige Funktionstüchtigkeit hinsichtlich der MEMS-Elemente durch eine Arrayanordnung gegeben, da bei einem Ausfall eines MEMS-Elements auch weitere MEMS-Elemente bei einem MEMS-Element-Array gegeben sind.

Der durchschnittliche Fachmann erkennt, dass technische Effekte und Vorteile, die für geometrische Ausgestaltungen eines Antennenarrays gelten, insbesondere in Bezug auf ein Beamforming von Signalen, ebenfalls auf analoge Weise für MEMS-Element-Array übertragen werden können, beispielsweise von akustischen Signale beim Einsatz eines MEMS-Wandler-Arrays.

In bevorzugten Ausführungsformen ist das MEMS-Element-Array ein MEMS-Mikrofon und/oder ein MEMS-Lautsprecher-Array. Mithilfe eines MEMS-Mikrofon-Arrays können vorteilhaft akustische Signale verstärkt und/oder mit einer Richtwirkung empfangen werden. Analog können mithilfe eines MEMS-Lautsprecher-Arrays akustische Signale verstärkt und/oder mit einer Richtwirkung emittiert werden. Im Sinne der Erfindung bezeichnet ein akustisches Signal bevorzugt eine Schallwelle. Vorteilhafterweise eignet sich ein MEMS-Mikrofon-Array und/oder ein MEMS-Lautsprecher für eine Vielzahl von vorteilhaften Anwendungen in Kombination mit einem Antennenarray auf dem Packagesubstrat sowie einer Recheneinheit, beispielsweise für eine Optimierung von Beamforming, eine Verbesserung der Lokalisierung und/oder bei einem Einsatz zur Geräuschkompensation. Bevorzugt kann eine Optimierung des Empfangs und/oder des Versendens von Signalen durch eine Formausgestaltung des Packagesubstrates erfolgen.

In einer weiteren bevorzugten Ausführungsform ist das MEMS-Package dadurch gekennzeichnet, dass das Packagesubstrat eine Packagesubstratoberfläche umfasst, wobei die Packagesubstratoberfläche mindestens teilweise einen planaren und/oder nicht-planaren Abschnitt aufweist, wobei bevorzugt der nicht-planare Abschnitt eine konkave oder konvexe Ausgestaltung umfasst.

Vorteilhafterweise kann das mindestens eine MEMS-Element und/oder die eine oder mehreren Antennen je nach Anwendungszweck auf einem planaren und/oder einem nicht-planaren Abschnitt aufgebracht werden, um vorzugsweise das Empfangen und/oder das Versenden von Signalen zu optimieren.

Im Sinne der Erfindung bezeichnet ein planarer Abschnitt bevorzugt einen Abschnitt des Packagesubstrates, der im Wesentlichen plan, d. h. eben, ausgestaltet ist. Das mindestens eine MEMS-Element und/oder die einen oder mehreren Antennen liegen vorzugsweise mithin in einer Ebene vor. Ein hohe Sensitivität hinsichtlich eines Senden und/oder Empfangen von Signalen erfolgt insbesondere in einer Vorzugsrichtung orthogonal zu der Ebene. Ein nicht-planarer Abschnitt bezeichnet im Sinne der Erfindung bevorzugt einen Abschnitt des Packagesubstrates, der nicht plan, d. h. nicht eben, ausgestaltet ist. Vorzugsweise zeichnet sich ein nicht-planarer Abschnitt des Packagesubstrates durch eine oder mehrere Wölbungen aus.

Ebenfalls ergeben sich vorteilhafte Möglichkeiten der Anbringung des mindestens einen MEMS-Elementes und/oder der einen oder mehreren Antennen auf einem nicht-planaren Abschnitt des Packagesubstrates. Bevorzugt umfasst der nicht-planare Abschnitt eine konkave oder eine konvexe Ausgestaltung. Im erfindungsgemäßen Kontext kann dies analog mit einem konkaven oder einem konvexen Abschnitt beschrieben werden.

In einer bevorzugten Ausführungsform liegt ein nicht-planarer Abschnitt in Form eines konvexen Abschnitts vor. Bevorzugt zeichnet sich ein konvexer Abschnitt oder eine konvexe Ausgestaltung des Packagesubstrates durch eine Wölbung nach innen bzw. einer Wölbung entgegengesetzt der Empfangs- bzw. Senderichtung der Antennen und/oder MEMS-Elemente aus. In der bevorzugten Ausführungsform liegen das mindestens eine MEMS-Elemente bzw. die eine oder mehreren Antennen mithin in einer Vertiefung der Oberfläche des Packagesubstrates vor.

Eine Anordnung der einen oder mehreren Antennen, bevorzugt in Form eines Antennenarrays, auf einem konvexen Abschnitt kann vorteilhafterweise eine Bündelung von versendeten und/oder empfangenen elektromagnetischen Signalen unterstützen, wodurch eine Richtwirkung erhöht werden kann. Analog trifft dies auch für versendete und/oder empfangen Signale für das mindestens eine MEMS-Element zu. Beispielsweise kann eine Anordnung akustischer MEMS-Wandler eine Bündelung empfangener oder gesendeter akustischer Signale unterstützen.

In einer bevorzugten Ausführungsform liegt ein nicht-planarer Abschnitt in Form eines konkaven Abschnitts vor. Bevorzugt zeichnet sich ein konkaver Abschnitt oder eine konkave Ausgestaltung des Packagesubstrates durch eine Wölbung nach außen bzw. einer Wölbung in der Empfangs- bzw. Senderichtung der Antennen und/oder MEMS-Elemente aus. In der bevorzugten Ausführungsform liegen das mindestens eine MEMS-Elemente bzw. die eine oder mehreren Antennen mithin auf einer Erhebung der Oberfläche des Packagesubstrates vor.

Liegt beispielsweise die eine oder mehreren Antennen auf einem konkaven Abschnitt vor, bevorzugt in Form eines Antennenarrays, kann ein möglichst weiter Abstrahl- bzw. Empfangswinkel erzielt werden. So können vorteilhaft elektromagnetische Signale mit besonders weitläufigen Winkeln empfangen und/oder versendet werden. Analog tritt dieser Effekt auf, wenn beispielweise mindestens ein MEMS-Element auf einem konkaven Abschnitt angebracht wird, beispielsweise in Form eines MEMS-Wandlers als MEMS-Mikrofon oder als MEMS-Lautsprecher. Vorteilhafterweise lassen sich durch bevorzugte Verfahren zur Bereitstellung des Packagesubstrates, insbesondere eines additives Fertigungsverfahrens (3D-Druck), bevorzugt eines multimateriellen additiven Fertigungsverfahrens, auf einfache Weise optimale geometrische Formen und/oder Abschnitte des Packagesubstrates bilden.

In einer weiteren bevorzugten Ausführungsform ist das MEMS-Package dadurch gekennzeichnet, dass das mindestens eine MEMS-Element und die eine oder mehreren Antennen auf demselben nicht-planaren Abschnitt vorliegen.

In bestimmten Ausführungsformen kann es bevorzugt sein, das mindestens eine MEMS-Element und/oder die eine oder mehreren Antennen auf unterschiedlichen nicht-planaren Abschnitten bereitzustellen. Vorteilhaft kann die Form der nicht-planaren Abschnitte auf die gewünschte Empfangs- bzw. Abstrahlcharakteristik der Antennen bzw. MEMS-Elemente separat angepasst werden.

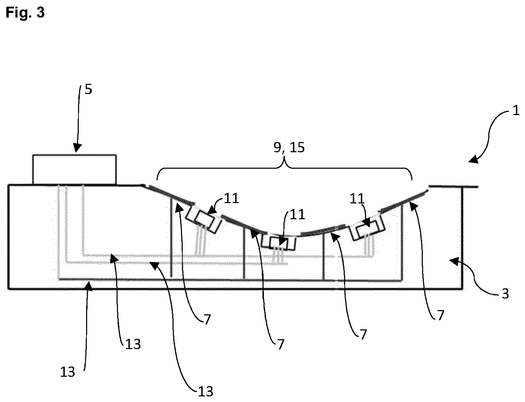

In anderen Ausführungsformen kann durch die Anbringung mindestens eines MEMS-Elements und der einen oder mehreren Antennen entlang eines selben nicht-planaren Abschnitts ein besonders kompaktes MEMS-Package bereitgestellt werden, welches sich durch eine einfache Bauweise und durch hervorragende Integrationsmöglichkeiten auszeichnet. Beispielsweise kann die Vorrichtung eine Vielzahl von MEMS-Elementen als MEMS-Element-Array aufweisen, wobei diese interkalierend mit einem Array von Antennen angeordnet sind (vgl. u.a. Fig. 3).

In einer weiteren bevorzugten Ausführungsform ist das MEMS-Package dadurch gekennzeichnet, dass das Packagesubstrat eine oder mehrere Ausnehmungen aufweist, wobei das mindestens eine MEMS-Element innerhalb der einen oder mehreren Ausnehmungen vorliegt.

Durch die Anbringung des mindestens einen MEMS-Elementes innerhalb einer Ausnehmung eines Packagesubstrates wird vorteilhaft ein optimaler Schutz gewährt. So wird es vermieden, dass fremde Substanzen in das MEMS-Bauteil gelangen und/oder das MEMS-Bauteil beschädigen. So wird vorteilhaft das MEMS-Element durch die Anbringung in einer Ausnehmung im Wesentlichen durch das Packagesubstrat umhüllt bzw. mindestens teilweise in diesem eingebettet, um eine Schutz- bzw. Gehäusefunktion zu erfüllen. Des Weiteren kann ein robuster Halt und vibrationsfeste Anordnung geschafft werden. Somit wird auch eine zuverlässige Funktionstüchtigkeit des mindestens einen MEMS-Elementes oder eines MEMS-Element-Arrays bei dynamischen Anwendungen gewährleistet. Darüber hinaus hat sich die Einbringung des mindestens einen MEMS-Elementes innerhalb einer Ausnehmung als herstellungseffizient erwiesen, da elektrische und/oder mechanische Kontaktierungen für das mindestens eine MEMS-Element einfach appliziert werden können.

Weiterhin ist die Anbringung des mindestens einen MEMS-Elementes in eine Ausnehmung dahingehend von Vorteil, dass vorteilhafte Effekte für die Funktionalität des MEMS-Element als solchem erzielt werden können. So kann beispielsweise durch eine geeignete Ausgestaltung der Ausnehmung ein nötiges Rückvolumen für einen MEMS-Wandler (insbesondere einen MEMS-Lautsprecher) geschaffen werden, um optimale akustische Eigenschaften zu erzielen.

Vorteilhafterweise lassen sich auch Abschnitte wie Ausnehmungen auf effiziente Weise durch die Bereitstellung des Packagesubstrates erlangen, beispielsweise während der Bereitstellung durch ein additives Fertigungsverfahren.

Bevorzugt liegt das mindestens eine MEMS-Element innerhalb einer Ausnehmung derart vor, dass das Packagesubstrat mindestens bereichsweise oberflächenkonform auf dem mindestens einen MEMS-Element vorliegt. Eine oberflächenkonforme Anbringung ist insbesondere eine Anbringung, welche im Wesentlichen direkt und formerhaltend eng an den Strukturen des MEMS-Elementes anliegt.

Im Wesentlichen direkt und enganliegend bedeutet bevorzugt, dass das Packagesubstrat mehrheitlich direkt aufliegt, jedoch in einigen Bereichen nicht durch Komponenten ausgefüllte Volumina miteinschließt, beispielsweise in Eckbereichen oder unterhalb eines Drahtbonds.

Die oberflächenkonforme Anbringung des Packagesubstrates ist vorzugsweise vollständig oberflächenkonform. Dies bedeutet insbesondere, dass die Schicht nahezu perfekt enganliegend bzw. oberflächenkonform ist und selbst kleinste Strukturen enganliegend beschichtet werden können. Kleinste Strukturen sind vorzugsweise Strukturen mit Abmessungen der Größenordnung maximal 10 Nanometer (nm), maximal 100 nm, maximal 1 Mikrometer (µm), maximal 10 µm oder maximal 100 µm.

In einer weiteren bevorzugten Ausführungsform ist das MEMS-Package dadurch gekennzeichnet, dass das mindestens eine MEMS-Element und/oder die eine oder mehreren Antennen sowie optional eine Recheneinheit miteinander über Leiterbahnen und/oder Durchkontaktierungen verbunden sind, wobei bevorzugt zumindest teilweise die Leiterbahnen und/oder die Durchkontaktierungen innerhalb des Packagesubstrates angebracht sind.

Bevorzugt dienen die Leiterbahnen und/oder Durchkontaktierungen der elektrischen Kontaktierung der Komponenten des bevorzugten MEMS-Packages. Mit einer elektrischen Kontaktierung ist bevorzugt eine elektrische Verbindung zwischen Komponenten des MEMS-Packages gemeint. So können mithilfe von Leiterbahnen und/oder Durchkontaktierungen das mindestens eine MEMS-Element, die eine oder mehreren Antennen und/oder die Recheneinheit miteinander in einer Datenverbindung stehen. Insbesondere können Messergebnisse hinsichtlich empfangener und/oder versendeter Signale, beispielsweise von elektromagnetischen Signalen durch die eine oder mehreren Antennen und/oder Signale des mindestens einen MEMS-Elementes, an die Recheneinheit übertragen werden, sodass diese durch die Recheneinheit sowie einer entsprechenden Software verarbeitet werden können.

Vorteilhaft können die Leiterbahnen und/oder die Durchkontaktierungen bereits durch den Herstellungsprozess des Packagesubstrates bereitgestellt werden, bevorzugt durch ein additives Fertigungsverfahren, besonders bevorzugt durch eine multimaterielle additive Fertigung. Vorteilhaft können somit elektrische Kontaktierungen durch Leiterbahnen und/oder Durchkontaktierung und die Bereitstellung des Packagesubstrates in einem, bevorzugt einzigen, Prozessablauf erfolgen.

Im Sinne der Erfindung sind Leiterbahnen bevorzugt aus einem leitfähigen Material hergestellte Streifen, welche bevorzugt eine höhere Länge als Breite aufweisen und zur elektrischen Verbindung bzw. Kontaktierung eingesetzt werden. In weiteren bevorzugten Ausführungsformen können Leiterbahnen auch einen im Wesentlichen zweidimensionalen Verlauf haben, um eine Leiterbahnebene oder Metallisierungsebene bereitzustellen.

Eine Durchkontaktierung bezeichnet im Sinne der Erfindung bevorzugt eine im Wesentlichen vertikale elektrische Verbindung, um Strom zu leiten. Die Durchkontaktierung kann bevorzugt ebenfalls während der Bereitstellung des Packagesubstrates erzeugt werden. Ebenfalls kann es bevorzugt sein, die Durchkontaktierung nach der der Bereitstellung des Packagesubstrates darin bereitzustellen, beispielsweise durch einen Ätzvorgang und eine daraufhin stattfindende Befüllung des Ätzbereiches durch ein elektrisch leitfähiges Material. Eine Durchkontaktierung kann sich bevorzugt im Wesentlich zwischen einer Vorder- und Rückseite des Packagesubstrat erstrecken. Ebenfalls kann es bevorzugt sein, dass die Durchkontaktierung nicht durch das im Wesentlichen ganze Packagesubstrat, sondern nur bis zu einer Zwischenschicht reicht. Weiterhin kann es bevorzugt sein, dass die Durchkontaktierung sich im Wesentlichen nur innerhalb des Packagesubstrates erstreckt.

In einer weiteren bevorzugten Ausführungsform umfasst die Leiterbahn und/oder die Durchkontaktierung ein Material ausgewählt aus einer Gruppe der Edelmetalle, d. h. ausgewählt aus einer Gruppe umfassend Gold, Platin, Iridium, Palladium, Osmium, Silber, Polonium, Rhodium, Ruthenium, Kupfer, Bismut, Technetium, Rhenium und/oder Antimon.

Die genannten Materialien haben sich für die Bereitstellung von elektrischen Verbindungen in Form von Leiterbahnen und/oder Durchkontaktierungen als besonders zuverlässig erwiesen, da sie einerseits während der Herstellung gut zu verarbeiten sind und andererseits eine hohe Beständigkeit aufweisen, sodass eine langanhaltende stabile elektrische Verbindung erlangt werden kann.

In einer weiteren bevorzugten Ausführungsform ist das MEMS-Package dadurch gekennzeichnet, dass das Packagesubstrat ein MEMS-Wandler-Array aufweist, bevorzugt ein MEMS-Mikrofon-Array und/oder ein MEMS-Lautsprecher-Array, und ein Antennenarray auf dem Packagesubstrat vorliegt sowie die Recheneinheit dazu konfiguriert ist, dass das Antennenarray elektromagnetische Signale und/oder das MEMS-Wandler-Array akustische Signale mittels Beamforming sendet und/oder empfängt.

Dem durchschnittlichen Fachmann ist bekannt, dass mittels Beamforming im Allgemeinen Signale eine Richtwirkung erhalten, sodass sie gezielter empfangen und/oder versendet werden können. Dazu werden vorzugsweise Interferenzeffekte genutzt, die durch eine Phasenverschiebung von empfangenen und/oder versendeten Signalen resultieren. Dementsprechend ist es bevorzugt, für die Anwendung des Beamforming ein Array zu nutzen, insbesondere ein Antennenarray für elektromagnetische Signale und/oder ein MEMS-Wandler-Array für akustische Signale.

So kann es bevorzugt sein, ein Beamforming von elektromagnetischen Signalen zu nutzen. Hierbei erfolgt eine Bündelung oder Ausrichtung von elektromagnetischen Wellen durch das Antennenarray beim Empfangen und/oder Versenden von elektromagnetischen Signalen. Vorteilhaft resultiert durch ein Beamforming von elektromagnetischen Signalen eine erweiterte Reichweite sowie eine stabilere Verbindung. Auch wird eine Signalübertragung weniger anfällig gegenüber Funkstörern und eine bessere Übertragungsleistung mit einer höheren Datenrate vorteilhaft erzielt.

Ebenfalls ist es bevorzugt, ein Beamforming von akustischen Signalen zu nutzen, um durch ein MEMS-Wandler-Array, bevorzugt MEMS-Mikrofon-Array und/oder MEMS-Lautsprecher-Array, zielgerichtet akustische Signale zu empfangen und/oder zu senden. In Bezug auf akustisches Beamforming bestehen ebenfalls weitreichende Anwendungsmöglichkeiten. Mittels Beamforming beim Empfangen akustischer Signale können beispielsweise ortsaufgelöst akustische zwei- und/oder dreidimensionale Schallaufnahmen (Fotos oder Videos) erstellt werden, welche ein leistungsstarkes Werkzeug für die Klanganalyse und/oder Geräuschreduzierung darstellt. Hierbei können mehrere Schallquellen lokalisiert und voneinander separiert werden. Zudem birgt akustisches Beamforming ein hohes Potential in Bezug auf eine Optimierung der Klangübertragung in geschlossenen wie offenen Räumen.

Für das Beamforming als solches ist es bevorzugt, dass eine entsprechende Software auf der Recheneinheit installiert ist. Mithin ist die Recheneinheit dazu konfiguriert, entsprechende Rechenoperationen für ein Beamforming auszuführen. Vorzugsweise können für das Beamforming Filter, wie analoge und/oder digitale Filter, sowie Phasenverschieber eingesetzt werden.

Folglich eignet sich das bevorzugte MEMS-Package umfassend einen MEMS-Lautsprecher-Array und/oder MEMS-Mikrofon-Array vorteilhaft sowohl für die Nutzung für ein Beamforming von akustischen als auch für ein Beamforming von elektromagnetischen Signalen.

In einer weiteren bevorzugten Ausführungsform ist das MEMS-Package dadurch gekennzeichnet, dass MEMS-Package eine Recheneinheit umfasst, welche dazu konfiguriert ist, dass für das Beamforming eine wechselseitige Verarbeitung der elektromagnetischen Signale und der akustischen Signale vorgenommen wird.

Besonders bevorzugt kann das MEMS-Package mithin zum Senden, Empfangen und Verarbeiten von elektromagnetischen und akustischen Signalen ausgelegt sein und einen ersten Antennenarray zum Senden von elektromagnetischen Signalen, einen zweiten Antennenarray zum Empfangen von elektromagnetischen Signalen, einen MEMS-Mikrofonarray zum Empfangen von akustischen Signalen, einen MEMS-Lautsprecherarray zum Senden von akustischen Signalen und eine Recheneinheit umfassen, wobei die Recheneinheit dazu konfiguriert ist, dass ein Senden und Empfangen der elektromagnetischen und/oder akustischen Signale durch die Vorrichtung mittels Beamforming erfolgt, wobei für das Beamforming eine kombinierte und/oder wechselseitige Verarbeitung elektromagnetischer und akustischer Signale vorgenommen wird.

Eine wechselseitige Verarbeitung für das Beamforming von akustischen und elektromagnetischen Signalen hat sich in vielen Aspekten als besonders vorteilhaft erwiesen.

So ist es durch den Einsatz einer wechselseitigen Verarbeitung von elektromagnetischen und akustischen Signalen vorteilhafterweise möglich, eine erhebliche Verbesserung hinsichtlich der Genauigkeit bei Lokalisierungen zu erzielen. Die höhere Genauigkeit begründet sich insbesondere damit, dass beide Signalarten für eine Positionsbestimmung verwendet werden können.

Im Stand der Technik dagegen war stets nur ein Beamforming für nur eine Signalart bekannt, beispielsweise ein Beamforming von akustischen Signalen oder von elektromagnetischen Signalen. Akustische Signale erlauben zumeist insbesondere eine gute Grobschätzung der Position, während elektromagnetische Signale vor allem für eine Feinschätzung geeignet sind.

Bei akustischen Signalen in akustischen Kanälen kann es zudem zu Verrauschungen kommen. Dies kann viele verschiedene Ursachen haben und geht mit diversen Rauscharten einher. Bei elektromagnetischen Signalen besteht insbesondere das Problem von Mehrwegeausbreitungen.

Weitere Probleme hinsichtlich der Übertragung von elektromagnetischen Signalen sind verrauschte Funkkanäle über ISM-Bänder (englisch: Industrial, Scientific and Medical Band) für WLAN oder Bluetooth. Viele Systeme nutzen diese Frequenzbänder, sodass es zu Einschränkungen der Signalqualität kommen kann.

In der bevorzugten Ausführungsform ist es hingegen bevorzugt, dass beispielsweise akustische Signale für eine Grobschätzung der Position und elektromagnetische Signale für eine Feinschätzung eingesetzt werden. Beispielsweise können durch eine Grobschätzung der akustischen Signale die Antennenarrays für die elektromagnetischen Signale auf die Quelle gerichtet werden, wobei die Verarbeitung durch die akustischen Signale bedingt durch die grobe Schätzung eine hohe Fehlertoleranz hinsichtlich der Positionsbestimmung aufweist. Die Antennenarrays, die für das Beamforming der elektromagnetischen Signale verantwortlich sind, können anschließend auf einen Bereich ausgerichtet werden, welcher durch die akustischen Signale zunächst (grob) ermittelt wurde.

Durch das Verarbeiten der hochauflösenden elektromagnetischen Signale wird die Fehlertoleranz nochmals verringert und die Position genauer bestimmt. Es stellt hierbei eine Abkehr vom Stand der Technik dar, dass beide Signalarten, also elektromagnetische und akustische Signale, miteinander in Kombination zur Positionsbestimmung verwendet werden. Durch die Verwendung beider Signalarten ist es mithin möglich, die Position mit einer höheren Genauigkeit zu bestimmen, wobei eine Grobschätzung durch die akustischen Signale und Feinschätzung durch die elektromagnetischen Signale gleichermaßen genutzt wird.

Ein weiterer Vorteil der bevorzugt wechselseitigen Verarbeitung unter Einsatz des bevorzugten MEMS-Packages ist es, dass die Rechenleistung erheblich reduziert werden kann, insbesondere bei einer Positionsbestimmung und/oder Optimierung der Strahlausrichtung.

Beispielsweise kann das MEMS-Lausprecherarray automatisch auf die durch die durch Antennenarrays berechnete Position ausgerichtet werden. Somit müssen durch das MEMS-Mikrofon-Array nicht weitere akustische Signale aufgenommen und/oder verarbeitet werden. Stattdessen kann das MEMS-Lautsprecher-Array direkt auf die Quelle durch die elektromagnetischen Signale ausgerichtet werden. Umgekehrt kann auch das Mikrofonarray die Grundlage für das Beamforming der elektromagnetischen Signale darstellen. Durch geeignete Algorithmen können somit Synergien genutzt werden, um die erforderliche Rechenleistung für das Beamforming zu optimieren.

Ein zusätzlicher Vorteil des bevorzugten MEMS-Packages ist, dass es gezielt zur Übertragung von Stereoeffekten genutzt werden kann. Ein Stereoeffekt bewirkt einen räumlichen Schalleindruck beim natürlichen Hören bei zwei oder mehr Schallquellen. Vorteilhafterweise können mit dem bevorzugten MEMS-Package besonders präzise Stereoeffekte übertragen werden, wobei sowohl auf die elektromagnetischen Antennenarrays als auch die MEMS-Lautsprecher bzw. MEMS-Mikrofonarrays zurückgegriffen werden kann.

Durch ein Beamforming von akustischen Signalen beim Senden mithilfe des Lautsprecherarrays kann zudem bevorzugt auf die Parallaxe beider Ohren gezielt gesendet werden. Währenddessen bleibt ein Empfang bzw. ein Hören (mittels der Mikrofonarrays) auf den Mund fokussiert. Dies ist von besonderem Vorteil, da eine Trennschärfe zwischen gleichzeitigem Senden und Empfangen von akustischen Signalen möglich wird. Gleichzeitig können elektromagnetischen Arrays genutzt werden, um die Position des Sprechers - beispielsweise anhand eines mitgeführten Mobilgerätes oder Reflektoren präziser zu bestimmen - oder einen Datenaustausch mit einem mitgeführten Mobilgerät durch das Beamforming zu optimieren.

Insbesondere in Großraumbüros oder anderen Orten, an denen sich mehrere Menschen gleichzeitig aufhalten und kommunizieren, können bevorzugte Ausführungsformen des MEMS-Package für einen Einsatz als Freisprechanlage sehr vorteilhaft sein. Beispielsweise kann es ermöglicht werden, dass sich ein Nutzer beispielsweise in einem Großraumbüro frei bewegen kann, während dieser ein durch das MEMS-Package unterstütztes Telefongespräch mit einer ausgezeichneten Tonqualität führt. Die Audiosignale für das Hören und Sprechen werden mittels Beamforming direkt an den Nutzer geleitet. Eine umständliche Handhabung von Headsets oder des Mobilgerätes ist nicht notwendig.

Weiterhin kann das MEMS-Package genutzt werden, um mittels Beamforming besonders präzise akustische Signale auszusenden, um unerwünschte Geräusche zu kompensieren. Dies kann beispielsweise am Arbeitsplatz in einem Großraumbüro oder in einem Fahrzeug zum Einsatz kommen. Hierbei kann das bevorzugte MEMS-Package die Richtung, aus der der unerwünschte Schall kommt, durch das Beamforming von empfangenen akustischen Signalen durch eine MEMS-Mikrofonarray und/oder unterstützt durch Antennenarrays erkennen. Zur Geräuschkompensation wird ein akustisches Signal ausgesendet, welches dafür konfiguriert ist, mittels destruktiver Interferenz den störenden Schall auszulöschen. Dazu kann beispielsweise von dem MEMS-Package ein Gegensignal erzeugt werden, das dem störenden Schall entspricht, jedoch eine entgegengesetzte Polarität aufweist. Ein solches Signal wird auch als Antischall bezeichnet.

Die bevorzugte Ausführungsform eines MEMS-Package mit einem MEMS-Lautsprecherarray, MEMS-Mikrofonarray sowie einem (oder zwei) Antennenarrays entfaltet somit insbesondere dort Vorteile, wo ein Freisprechen genutzt wird und/oder eine gezielte Geräuschkompensation erwünscht ist, beispielsweise in Großraumbüros Fahrzeugen, in Messehallen, in Konzerthallen usw.

Eine wechselseitige Verarbeitung von elektromagnetischen und akustischen Signalen bezeichnet bevorzugt, dass die akustischen Signale eine Grundlage für das Beamforming der elektromagnetischen Signale oder dass die elektromagnetischen Signale eine Grundlage für das Beamforming der akustischen Signale sein kann.

Eine kombinierte Verarbeitung bezeichnet bevorzugt, dass elektromagnetische und akustische Signale in Kombination eine Grundlage für das Beamforming einer der beiden Signalarten oder für beide Signalarten in Kombination darstellen.

In einer bevorzugten Ausführungsform umfasst das Senden und/oder das Empfangen von elektromagnetischen Signalen eine Verarbeitung von empfangenen akustischen Signalen.

Insbesondere können also vorzugsweise akustische Signale von dem MEMS-Package empfangen werden, welche für ein Beamforming der elektromagnetischen Signale genutzt werden. Durch die empfangenen akustischen Signale durch ein Mikrofonarray kann insbesondere hinsichtlich der Lokalisierung eine Grobschätzung der Position vorgenommen werden. Konkret wird die Grobschätzung bevorzugt durch eine Software, welche mindestens teilweise auf einer Recheneinheit installiert vorliegt, vorgenommen. Auf Basis der Grobschätzung können durch das ein Antennenarray zum Senden von elektromagnetischen Signalen diese initial an eine ermittelte Position versendet werden, wobei auf Basis der empfangenen elektromagnetischen Signale auch eine Feinjustierung möglich ist.

In einer bevorzugten Ausführungsform umfasst das Senden und/oder das Empfangen von akustischen Signalen eine Verarbeitung von empfangenen elektromagnetischen Signalen.

Es kann auch bevorzugt sein, dass auf Basis der empfangenen elektromagnetischen Signale (durch ein Antennenarray) akustische Signale gezielt ausgesendet und/oder empfangen werden. Mittels der empfangenen elektromagnetischen Signale können akustische Signale über ein Beamforming durch das Lautsprecherarray versendet oder mittels des Mikrofonarrays gezielt empfangen werden. Damit wird der Schall vorteilhafterweise präzise auf einen gewünschten Bereich emittiert bzw. von einem Bereich empfangen. Wie eingangs erläutert, kann hierdurch beispielsweise Schall gezielter auf die Hörorgane eines Nutzers übertragen oder von einem Sprechorgan empfangen werden, sodass Telefonate, das Hören von Musik etc. auch während der Bewegungen eines Nutzers durch den Raum mit unverminderter Qualität fortgesetzt werden kann. Die verbesserte Lokalisierung aufgrund der Auswertung elektromagnetischer Signale erlaubt hierbei eine Verbesserung der Qualität und des Beamformings der akustischen Signale.

In einer bevorzugten Ausführungsform umfasst das Senden und/oder Empfangen von elektromagnetischen und/oder akustischen Signalen eine Verarbeitung von empfangenen akustischen und elektromagnetischen Signalen.

Dies hat den Vorteil, dass durch das Senden und/oder Empfangen von elektromagnetischen und akustischen Signalen ein ständiger Austausch stattfindet und somit die Position mit hoher Präzision durch eine Recheneinheit ermittelt wird. Damit geht ebenfalls einher, dass beispielsweise während eines Telefonats insbesondere die Signalqualität weder der akustischen Signale noch der elektromagnetischen Signale leidet, da durch eine kombinierte Verarbeitung ein optimiertes Beamforming für beide Signalarten erfolgt.

Der gezielte Austausch mittels Beamforming von elektromagnetischen Signalen kann beispielsweise durch das Tragen eines WiFi-Tags unterstützt werden. Insbesondere können sich ein oder mehrere Antennenarrays, ein MEMS-Lautsprecherarray und/oder ein MEMS-Mikrofonarray mit dem WiFi-Tag verbinden. Es kann auch bevorzugt sein, dass der ständige Austausch von elektromagnetischen Signalen zwischen der erfindungsgemäßen Vorrichtung und einem anderen Gerät, beispielsweise ein Smartphone, das der Nutzer mit sich führt, stattfindet. Jedes Gerät, welches geeignete elektromagnetische Signale aussenden kann, kann zur verbesserten Positionsbestimmung des Nutzers genutzt werden. Vorteilhaft kann in Bezug auf Freisprechanalgen hierdurch weitestgehend auf Peripheriegeräte, wie Kopfhörer oder Headsets verzichtet werden.

Die Möglichkeiten der Nutzung einer kombinierten und/oder wechselseitigen Verarbeitung akustischer oder elektromagnetischer Signale sind vielseitig. Im Stand der Technik erfolgte ein Beamforming stattdessen isoliert nur für eine Signalart. Es stellt somit eine wesentliche Abkehr vom Stand der Technik dar, dass unter Verarbeitung von empfangenen akustischen Signalen elektromagnetische Signale ausgesendet werden (oder umgekehrt) und/oder ein Empfangen/Senden von akustischen/elektromagnetischen Signalen auf Basis einer kombinierten Verarbeitung der beiden Signalarten erfolgt.

In bevorzugten Ausführungsformen kann das Versenden und/oder Empfangen von elektromagnetischen Signalen mit einem ersten und einem zweiten Antennenarray erfolgen. In weiteren bevorzugten Ausführungsformen kann das Versenden und/oder Empfangen von elektromagnetischen Signalen mittels eines einzigen Antennenarrays erfolgen. Das erste Antennenarray und das zweite Antennenarray können somit in einem Antennenarray vereint sein, beispielsweise in Form eines Antennenarrays, welcher im Halbduplex betrieben wird.

In einer weiteren bevorzugten Ausführungsform ist das MEMS-Package dadurch gekennzeichnet, dass MEMS-Package eine Recheneinheit umfasst, welche dazu konfiguriert ist, eine Lokalisierung von Objekten und/oder Nutzern über empfangene und/oder gesendete elektromagnetische Signale und akustische Signale vorzunehmen.

Dazu kann die erfindungsgemäße Vorrichtung bevorzugt diverse Methoden der Lokalisierung nutzen, um Objekte und/oder Nutzer zu lokalisieren. Die Bezeichnung der bevorzugten Methoden erfolgt nach den Informationen, die sie für die Positionsbestimmung verwenden: Verbindungsinformationen (CoO, engl. Cell of Origin), Empfangswinkel der Signale (AoA, engl. Angle of Arrival), Empfangszeitpunkte der Signale (ToA, engl. Time of Arrival), Bidirektionale Umlaufzeit des Signals (RToF, engl. Round-trip Time of Flight), Zeitdifferenzen der eingehenden Signale (TDoA, engl. Time Difference of Arrival) und Signalstärken der eingehenden Signale (RSSI, engl. Received Signal Strength Indicator).

Es ist bekannt, dass Verbindungsinformationen fast in jedem drahtlosen Funknetz vorhanden sind. Die Genauigkeit hängt bei diesem Verfahren mit der Granularität und Größe der Zellen im verwendeten Funknetz zusammen. Bei diesem auch "Cell of Origin" (CoO) genannten Verfahren wird die Position anhand der mit dem mobilen Knoten assoziierten ortsfestem Knoten bestimmt. Jedem ortsfesten Knoten und damit auch der Zelle ist eine eindeutige Identifizierung (Cell-ID) zugeordnet. Die Positionen der ortsfesten Knoten müssen bekannt sein.

Das AoA-Verfahren verwendet die Einfallswinkel der empfangenen Signale. Dabei werden mindestens zwei ortsfeste Knoten mit Richtantennen benötigt. Mit den empfangenen Signalen von einem mobilen Knoten kann der Einfallswinkel des Signals bestimmt werden. Die Berechnung der Distanz zu den bekannten Positionen der ortsfesten Stationen erfolgt mittels Triangulation. Dabei werden die Winkelbeziehungen innerhalb eines Dreiecks genutzt. Über die bekannte Distanz zwischen den ortsfesten Knoten und den beiden gemessenen Einfallswinkeln kann die Position des mobilen Knotens berechnet werden.

Das ToA-Verfahren bestimmt anhand der Signallaufzeit eines Signals die Distanz zwischen zwei Knoten. Im gesendeten Frame ist die Sendezeit t₀ mitenthalten, sodass im Empfänger der Abstand d aus der Empfangszeit t₁ und der Signalausbreitungsgeschwindigkeit c bestimmt werden kann. Voraussetzung für das ToA-Verfahren ist zumeist eine hochgenaue Synchronisation von Uhren, die sich auf beiden Knoten befinden müssen, damit die Laufzeit exakt bestimmt werden kann.

Beim RToF-Verfahren wird die Umlaufzeit eines Signals gemessen. Der Empfänger bestätigt den Empfang des Signals mit einem sogenannten Acknowledgement-Frame, indem auch die Verarbeitungszeit im Empfänger tp enthalten ist. Eine Synchronisation der Uhren der Knoten ist nicht notwendig, da keine absoluten Zeiten zwischen Sender und Empfänger benötigt werden. Für die Erzeugung des Acknowledgement-Frames wird im Empfänger im Vergleich zur Signallaufzeit eine relativ große Zeitspanne benötigt. Dies führt zu einem Messfehler, falls die Uhren beider Knoten während der Messung auseinanderlaufen (Clock Drift). Dieser Fehler kann ausgeglichen werden, wenn RToF von beiden Seiten aus initiiert wird. Sind die Distanzen zu mindestens drei ortsfesten Knoten bestimmt, kann mit der Trilateration eine Position im zweidimensionalen Raum berechnet werden. Im Gegensatz zur Triangulation werden bei der Trilateration nur die Entfernungen zu den ortsfesten Knoten benötigt, dadurch ist dieses Verfahren deutlich leichter zu implementieren, da die Anforderungen an eine Hardware zur Distanzmessung deutlich geringer sind als die für die Bestimmung des Einfallswinkels eines empfangenen Signals.

Als TDoA-Verfahren werden zwei unterschiedliche Verfahren bezeichnet. Bei einem TDoA-Verfahren sendet ein Knoten gleichzeitig zwei Signale mit unterschiedlicher Signalausbreitungsgeschwindigkeit aus. Aus den unterschiedlichen Empfangszeitpunkten t₀ und t₁ kann im Empfänger die Distanz zum Sender bestimmt werden. Typischerweise wird neben einem Funksignal ein Ultraschallsignal verwendet. Da die Lichtgeschwindigkeit wesentlich größer als die Schallgeschwindigkeit ist, kann die Laufzeit des Funksignals bei der Berechnung der Distanz d vernachlässigt werden. Bei dem anderen TDoA-Verfahren berechnen die ortsfesten Empfänger die Position eines mobilen Senders aus der Differenz der Empfangszeitpunkte des Signals. Dieses Verfahren wird im Mobilfunk auch als Observed Time Difference of Arrival (OTDoA) bezeichnet. Der Vorteil gegenüber dem ToA-Verfahren liegt darin, dass keine Synchronisation zwischen den mobilen Knoten und den ortsfesten Knoten vorhanden sein muss. Somit wird keine hochpräzise Uhr in den mobilen Knoten benötigt.

RSSI-Verfahren bezeichnen Verfahren, die die empfangenen Signalstärken für die Positionsbestimmung nutzen. Bei der Berechnung der Distanz zu einem ortsfesten Knoten wird die Freiraumdämpfung berücksichtigt, die besagt, dass die Signalstärke mit der Distanz zum Sender quadratisch abnimmt. Über Trilateration kann dann die Position des mobilen Knotens im zweidimensionalen Raum berechnet werden. Meist verwenden RSSI-Verfahren zur Lokalisierung in Gebäuden Fingerprinting. Ein Fingerprinting-Verfahren verwendet eine Radio-Map, in der die Signalstärken mit einer Position abgespeichert werden. Das Verfahren ist in zwei Phasen unterteilt. In der Kalibrierungsphase werden die empfangenen Signalstärken an vorher definierten Positionen in der Radio-Map abgespeichert. In der Lokalisierungsphase bewegt sich der mobile Knoten in der gleichen Umgebung. Dabei werden die aktuell gemessenen Signalstärkewerte mit denen aus der Radio-Map verglichen. Metriken für den Vergleich der Signalstärkewerte sind der Euklidische Abstand, der Bayes-Algorithmus oder die Delaunay-Triangulation mit konstanten Signalstärkekennlinien.

Insbesondere kann ein bevorzugtes MEMS-Package diese Möglichkeiten und/oder verschiedene dieser Möglichkeiten in Kombination zur Positionsbestimmung nutzen. Dabei können sowohl akustische und/oder elektromagnetische Signale für die Lokalisierung genutzt werden. Beispielsweise kann es bevorzugt sein, dass eine Ortung über eine Überlagerung von Triangulationssystemen erfolgt, z. B. das AoA-Verfahren mit akustischen Signalen und das AoA-Verfahren für elektromagnetische Signale. Es kann aber auch bevorzugt sein, dass verschiedene und mehrere Überlagerungen von Ortungsverfahren herangezogen werden.

Im Sinne der Erfindung bezeichnet ein Funknetz bevorzugt ein Kommunikationsnetz, in welchem Informationen mittels elektromagnetischer Signale übertragen werden. Bevorzugt ist ein Funknetz ein leitungsloses Telekommunikationsnetz, bei dem Methoden der Funktechnik, insbesondere die eben genannten Möglichkeiten zur Positionsbestimmung, genutzt werden können. Bevorzugt umfasst ein Funknetz mehrere Netzwerkknoten, welche auch Verbindungspunkte der Datenübertragungen darstellen. Ein Netzwerkknoten kann insbesondere also ein Zwischenknoten oder ein Endknoten bei der Datenübertragung sein.

Funknetze können auf unterschiedliche Arten klassifiziert werden. Eine Klassifikation erfolgt insbesondere über die Koordination der Netzwerkknoten im Infrastruktur-Netzwerk oder Ad-hoc-Netz. Weiterhin kann die eingesetzte Funktechnik betrachtet werden, insbesondere über Bluetooth (IEEE 802.15, WPAN), WLAN (IEEE 802.11), WiMAX (IEEE 802.16), GSM, UMTS und/oder 5G. Die Kommunikationsbeziehung der Systeme ist ebenfalls von Bedeutung, da beispielsweise ein Sender an einen Empfänger senden (unicast) kann, an alle möglichen Empfänger (broadcast), an eine definierte Gruppe aller Empfänger (multicast) oder an (mindestens) einen beliebigen Empfänger aus einer Gruppe (anycast). Vorteilhafterweise kann sich die erfindungsgemäße Vorrichtung mit verschieden, auch den o.g., Funknetzen verbinden und/oder ein Beamforming mit diesen Geräten durchführen.

In einer weiteren bevorzugten Ausführungsform werden die gesendeten und/oder empfangenen akustischen Signale für eine Grobschätzung und die gesendeten und/oder empfangenen akustischen Signale für eine Feinschätzung der Lokalisierung genutzt werden.

Eine Grobschätzung meint vorzugsweise eine Lokalisierung mit einer Winkelgenauigkeit von ca. 1° bis ca. 20° und einer örtlichen Genauigkeit von ca. 5 m bis ca. 50 m, während eine Feinschätzung vorzugsweise eine Winkelgenauigkeit von ca. 0,5° bis ca. 5° und eine örtliche Genauigkeit von ca. 0,1 m bis ca. 5 m meint.

Begriffe wie im Wesentlichen, ungefähr, etwa, ca. etc. beschreiben bevorzugt einen Toleranzbereich von weniger als ± 40%, bevorzugt weniger als ± 20%, besonders bevorzugt weniger als ± 10 %, noch stärker bevorzugt weniger als ± 5% und insbesondere weniger als ± 1% und umfassen stets den exakten Wert. Ähnlich beschreibt bevorzugt Größen, die ungefähr gleich sind. Teilweise beschreibt bevorzugt zu mindestens 5 %, besonders bevorzugt zu mindestens 10 %, und insbesondere zu mindestens 20 %, in einigen Fällen zu mindestens 40 %.

Für die Bereitstellung eines derart kombinierten Beamforming sowohl von akustischen als auch elektromagnetischen Signalen hat sich das erfindungsgemäße MEMS-Package als besonders vorteilhaft erwiesen, da eine Integration dafür benötigter Arrays von MEMS-Mikrofonen, MEMS-Lautsprechen und/oder Antennen auf besonders einfache Weise möglich ist.

Ein MEMS-Lautsprecher oder MEMS-Mikrofon bezeichnet bevorzugt einen Lautsprecher bzw. Mikrofon, welche auf einer MEMS-Technologie basiert und dessen klangerzeugende oder klangaufnehmenden Strukturen mindestens teilweise eine Dimensionierung im Mikrometerbereich (1 µm bis 1000 µm) aufweisen. Bevorzugt kann eine schwingfähige Membran in Breite, Höhe und/oder Dicke eine Dimension im Bereich von weniger als 1000 µm aufweisen.

Die schwingfähige Membran ist bevorzugt zur Erzeugung oder Aufnahme von Druckwellen des Fluids eingerichtet. Bei dem Fluid kann es sich sowohl um ein gasförmiges als auch flüssiges Fluid handeln, bevorzugt handelt es sich um Schalldruckwellen. Ein MEMS-Mikrofon oder MEMS-Lautsprecher wandelt mithin bevorzugt Druckwellen (z.B. akustische Signale als Schallwechseldrücke) in elektrische Signale um oder umgekehrt (Umwandlung elektrischer Signale in Druckwellen, beispielsweise akustische Signale). Mittels der Recheneinheit können bevorzugt die schwingfähige Membran, dessen Schwingungen beispielsweise durch piezoelektrische, piezoresistive oder kapazitives Komponenten an der Membran erzeugt und/oder ausgelesen werden.

Bevorzugt können beispielsweise kapazitive MEMS-Mikrofone in weitreichend automatisierten Prozessen bevorzugt unter Nutzung von Halbleiter-Technologien hergestellt werden. Hierbei können in einem Wafer zunächst Schichten aus unterschiedlichen Materialien abgeschieden werden. Anschließend wird nicht benötigtes Material durch Ätzverfahren entfernt. Auf diese Weise lässt sich eine bewegliche, schwingfähige Membran und ggf. eine Rückwand über einem Hohlraum im Wafer bereitstellen. Die Rückwand kann als starre Struktur ausgebildet werden, die dank Perforation/Öffnungen auch von Luft durchströmt werden kann. Die Membran ist bevorzugt eine hinreichend dünne schwingfähige Struktur, die sich unter dem Einfluss der von den Schallwellen verursachten Luftdruckänderungen durchbiegt. Während die Membran schwingt, bewegt sich die dickere Rückwand nicht, da die Luft durch ihre Öffnungen strömen kann. Die Bewegungen der Membran haben zur Folge, dass sich die Kapazität zwischen ihr und der Rückwand ändert. Diese Kapazitätsänderung kann von einer in das MEMS-Mikrofon eingebauten elektrischen Schaltung, beispielsweise ein ASIC, oder der zentralen Recheneinheit in ein elektrisches Signal umgewandelt werden. Die elektrische Schaltung misst Spannungsänderungen, die entstehen, wenn sich die Kapazität zwischen der Membran und der starren Rückwand ändert, weil sich die flexible Membran unter dem Einfluss der Schallwellen bewegt. Ein Schalleinlass kann sich beispielsweise entweder im Deckel befinden (Top-Port-Ausführung) oder an der Unterseite in der Nähe der Lötflächen (Bottom-Port-Ausführung).

Ein MEMS-Lautsprecher kann wie ein MEMS-Mikrofon aufgebaut sein, jedoch umgekehrt wirken, d. h. ein elektrisches Signal, welches durch die elektrische Schaltung generiert wird, sorgt für eine Bewegung der schwingfähigen Membran, sodass Schall emittiert wird.

MEMS-Mikrofone und/oder MEMS-Lautsprecher zeichnen sich durch ihre kompakte Bauweise aus, sodass sie sich einfach in dem erfindungsgemäßen Packagesubstrat zu Arrays anordnen lassen und besonders gut geeignet sind, um Beamforming an akustischen Signalen anzuwenden.

Vorzugsweise haben die Mikrofone und die Lautsprecher in ihrer Arrayausgestaltung, insbesondere die MEMS-Mikrofone und die MEMS-Lautsprecher, einen Abstand zueinander, der kleiner als die halbe Wellenlänge des akustischen Signals ist, insbesondere um das Nyquist-Shannon-Abtasttheorem zu erfüllen.

Die MEMS-Technologie erlaubt hierbei vorzugsweise eine Vielzahl von MEMS-Lautsprechern und/oder MEMS-Mikrofonen, beispielsweise 5, 10, 20, 50, 100 oder 500 oder mehr, in beliebiger Formation als ein Array anzuordnen und vorteilhaft die beschriebenen Lokalisierungsverfahren wie z.B. AOA, TOA, TDOA etc. für ein Beamforming zu verwenden.

Durch die Bereitstellung des Packagesubstrates ist eine separate Verkapselung der Vielzahl von MEMS-Elementen nicht notwendig, sondern kann auf einfache und kompakte in einem MEMS-Package erfolgen.

In einer bevorzugten Ausführungsform ist umfassen die eine oder mehrere Antennen zum Empfangen und/oder zum Senden von elektromagnetischen Signalen Phased-Array-Antennen.

Eine Phased-Array-Antenne bezeichnet bevorzugt eine Gruppenantenne, deren einzelnen Strahler mit unterschiedlicher Phasenlage gespeist werden können. Im Resultat kann das gemeinsame Antennendiagramm elektronisch geschwenkt werden. Die elektronische Schwenkung ist vorteilhafterweise sehr viel flexibler und wartungsärmer als eine mechanische Schwenkung der Antenne. Das entscheidende Prinzip bei Phased-Array-Antennen ist das der Interferenz, d. h. eine phasenabhängige Überlagerung von zwei oder (meist) mehreren Strahlern. Das bedeutet, dass sich gleichphasige Signale verstärken und gegenphasige Signale gegenseitig auslöschen. Wenn also zwei Strahler im gleichen Takt ein Signal aussenden, wird eine Überlagerung erzielt - das Signal wird in der Hauptrichtung verstärkt und in den Nebenrichtungen abgeschwächt. Wenn nun das auszustrahlende Signal durch eine die Phase regelnde Baugruppe geleitet wird, kann also die Abstrahlrichtung elektronisch gesteuert werden. Das ist in der Regel nicht unbegrenzt möglich, weil die Effektivität dieser Antennenanordnung in einer senkrecht zum Antennenfeld liegenden Hauptrichtung am größten ist, während bei einer extremen Schwenkung der Hauptrichtung die Anzahl und die Größe der unerwünschten Nebenkeulen steigt, während gleichzeitig die effektive Antennenfläche verkleinert wird. Mit dem Sinussatz kann die nötige Phasenverschiebung errechnet werden. Es können beliebige Antennenkonstruktionen als Strahler in einem Antennenfeld verwendet werden. Für eine Phased-Array-Antenne ist von Bedeutung, dass die einzelnen Strahler mit einer geregelten Phasenverschiebung angesteuert werden und somit die Hauptrichtung der Abstrahlung verändert wird. Um eine Bündelung sowohl horizontal als auch vertikal zu erreichen, werden vorzugsweise viele Strahler in einem Antennenfeld verwendet.

Der Einsatz von Phased-Array-Antennen für elektromagnetische Signale bringt diverse Vorteile mit sich. Unter anderem liefern Phased-Array-Antennen einen hohen Antennengewinn bei gleichzeitig großer Nebenkeulendämpfung. Der Antennengewinn fasst die Richtwirkung und den Wirkungsgrad einer Antenne zusammen. Des Weiteren ist sehr vorteilhaft, dass ein schneller Wechsel der Strahlrichtung im Mikrosekundenbereich möglich ist. Was auch von großem Vorteil ist, dass die Diagrammformung, insbesondere die Diagrammumformung, sehr schnell passiert, was auch als Beam agility bekannt ist. Zudem können Phased-Array-Antennen eine beliebige Abtastung eines Raumes oder eines Raumbereiches umfassen. Zudem haben Phased-Array-Antennen eine frei wählbare Zielbeleuchtungsdauer, sodass ein dauerhaftes und zuverlässiges Abstrahlen von elektromagnetischen Signalen ermöglicht wird. Es ist ebenfalls erwähnenswert, dass durch das gleichzeitige Erzeugen von mehreren Strahlen ein Multifunktionsbetrieb durchführbar ist. Von großem Vorteil ist es hierbei, dass der Ausfall einer einzelnen Komponente nicht zwangsläufig zu einem kompletten Ausfall des Systems führt.

Phased-Array-Antennen können als lineare und/oder als planare Arrays ausgebildet sein.

Die linearen Phased-Array-Antennen umfassen Zeilen, die gemeinsam über einen Phasenschieber gesteuert werden. Daher wird nur ein Phasenschieber pro Antennenzeile benötigt. Eine Vielzahl senkrecht übereinander angeordneter linearer Arrays bilden eine ebene Antenne. Vorteilhafterweise ergibt sich hierdurch eine besonders einfache Anordnung. Allerdings ist eine Strahlschwenkung zumeist nur in einer Ebene möglich.

Die planaren Phased-Array-Antennen werden bevorzugt vollständig aus Einzelelementen mit jeweils einem Phasenschieber pro Element umfasst. Jeder Einzelstrahler benötigt einen eigenen Phasenschieber. Die Elemente werden wie in einer Matrize angeordnet, die ebene Anordnung aller Elemente bildet die gesamte Antenne. Vorteilhafterweise erfolgt hierbei eine Strahlschwenkung in zwei Ebenen.

In einem weiteren Aspekt betrifft die Erfindung ein Verfahren zur Herstellung eines MEMS-Packages entsprechend einem oder mehreren der angehängten Patentansprüche umfassend folgende Schritte:
a) Bereitstellung eines Packagesubstrates und/oder von Leiterbahnen durch ein additives Fertigungsverfahren, bevorzugt ein multimaterielles additives Fertigungsverfahren,
b) mindestens teilweise Einbettung mindestens eines MEMS-Elements umfassend einen MEMS-Interaktionsbereich, sodass zumindest der MEMS-Interaktionsbereich frei bleibt,
c) Anbringung einer oder mehrerer Antennen auf dem Packagesubstrat,
d) optionale Anbringung einer Recheneinheit auf oder in dem Packagesubstrat.

Der durchschnittliche Fachmann erkennt, dass technische Merkmale, Definitionen und Vorteile bevorzugter Ausführungsformen, welche für das erfindungsgemäße MEMS-Package offenbart wurden, gleichermaßen für ein Verfahren zu dessen Herstellung gelten, und umgekehrt. Vorteilhafterweise kann durch den Einsatz eines additiven Fertigungsverfahrens, bevorzugt eines multimateriellen additiven Fertigungsverfahrens, das Packagesubstrat besonders einfach und effizient bereitgestellt werden. Besonders vorteilhaft ist der Umstand, dass bereits während der Erstellung des Packagesubstrates Komponenten wie beispielsweise Leiterbahnen und/oder Durchkontaktierungen angebracht werden können, um elektrische Verbindungen bereitzustellen. So müssen die Komponenten nicht erst nachträglich am Packagesubstrat aufgebracht werden. Stattdessen kann das Packagesubstrat mit darauf vorliegenden Komponenten wie z. B. Leiterbahnen besonders prozesseffizient hergestellt werden.

Darüber hinaus ist es von großem Vorteil, dass durch ein additives Fertigungsverfahren eine besonders einfache Formgebung des Packagesubstrates ermöglicht wird. So können mit hoher Präzision feine Strukturen des Packagesubstrates erzielt werden, wie beispielsweise planare Abschnitte, nicht-planare Abschnitte wie z. B. konkave und/oder konvexe Abschnitte, und/oder Ausnehmungen für eine spätere Platzierung von MEMS-Elementen.

Darüber hinaus eignet sich das bevorzugte Verfahren ebenfalls gut im Rahmen einer Massenproduktion, sodass innerhalb einer vergleichsweisen kurzen Zeit eine hohe Stückzahl an MEMS-Packages hergestellt werden kann, bei anfallenden niedrigen Produktionskosten. Mithin erzielt das bevorzugte Verfahren vorteilhaft eine erhebliche Wirtschaftseffizienz. Dabei ist es von besonderem Vorteil, dass die einzelnen MEMS-Packages im Rahmen einer Massenproduktion im Wesentlichen identische Eigenschaften in Bezug auf ihre dielektrischen Eigenschaften aufweisen, insbesondere in Bezug auf die relative Permittivität. So weisen beispielsweise die einzelnen MEMS-Packages im Wesentlichen gleiche relative Permittivitäten auf, was einerseits eine besonders zuverlässige Herstellung als solche als auch optimale Nutzungszwecke für Hochfrequenzanwendungen bietet.

Bevorzugt wird zunächst das Packagesubstrat und/oder Leiterbahnen durch ein additives Fertigungsverfahren, bevorzugt durch ein multimaterielles additives Fertigungsverfahren bereitgestellt. Vorzugsweise wird zunächst das Modell des Packagesubstrates in eine entsprechende Anlage zur Durchführung des additiven Fertigungsverfahrens angegeben. Insbesondere ist es bevorzugt, dass das Packagesubstrat derart ausgestaltet wird, dass das Packagesubstrat planare und/oder nicht-planare Abschnitte aufweist. Weiterhin ist es bevorzugt, dass das Packagesubstrat Ausnehmungen aufweist für MEMS-Elemente.

Nachdem das Packagesubstrat bereitgestellt wurde, ist es bevorzugt, dass mindestens eine MEMS-Element umfassend einen MEMS-Interaktionsbereit derart in das Packagesubstrat einzubetten, sodass der MEMS-Interaktionsbereich frei bleibt. Durch die bevorzugten Ausnehmungen des Packagesubstrates ist die zumindest teilweise Einbettung des mindestens einen MEMS-Elements innerhalb des Packagesubstrates besonders einfach möglich.

Bevorzugt erfolgt eine Anbringung von einer oder mehreren Antennen auf dem Packagesubstrat, mit denen elektromagnetischen Signale empfangen und/oder versendet werden können.

Weiterhin ist es bevorzugt, dass optional eine Recheneinheit auf oder in dem Packagesubstrat angebracht wird. Vorzugsweise ist die Recheneinheit dazu konfiguriert, Rechenoperationen für Anwendungszwecke auszuführen, die eine Verarbeitung von elektromagnetischen Signalen und/oder Signalen, die mithilfe des mindestens einen MEMS-Elementes empfangen oder versendet werden kann, betrifft. Vorteilhafterweise stehen Komponenten des bevorzugten MEMS-Packages, wie z. B. das mindestens eine MEMS-Element, die eine oder mehreren Antennen und/oder die Recheneinheit durch eine elektrische Kontaktierung über Leiterbahnen und/oder Durchkontaktierungen in einer Datenverbindung miteinander.

Die erfindungsgemäßen Aspekte, insbesondere das bevorzugte MEMS-Package, sollen im Folgenden anhand von Beispielen näher erläutert werden, ohne auf diese Beispiele beschränkt zu sein.

### FIGUREN

### Kurzbeschreibung der Figuren

- **Fig. 1**: Schematische Darstellung eines bevorzugten MEMS-Packages
- **Fig. 2**: Schematische Darstellung eines Funktionsprinzips eines bevorzugten MEMS-Packages
- **Fig. 3**: Weitere schematische Darstellung eines bevorzugten MEMS-Packages

### Detaillierte Beschreibung der Figuren

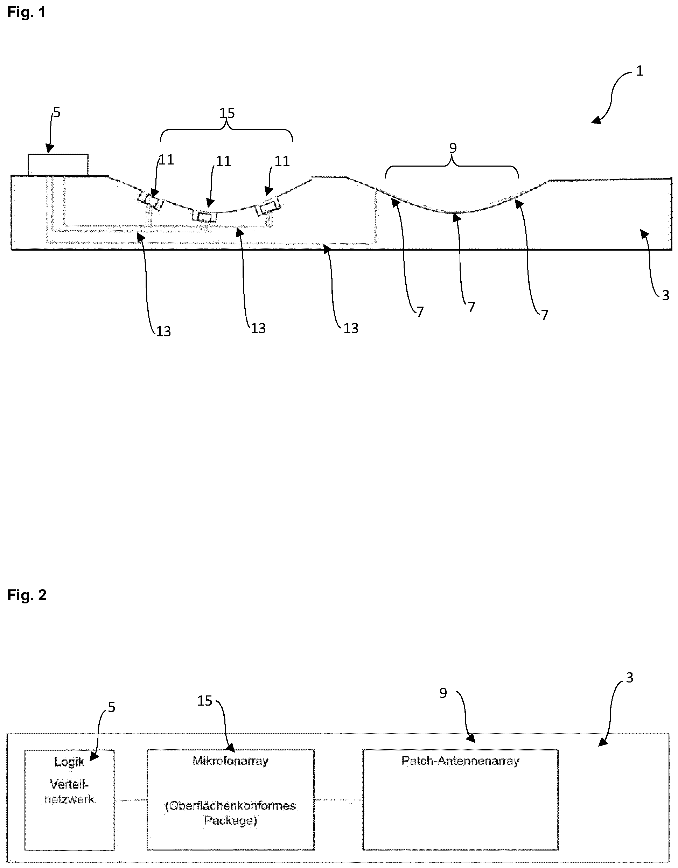

**Fig. 1** zeigt eine schematische Darstellung eines bevorzugten MEMS-Packages **1.** Das MEMS-Package **1** umfasst ein Packagesubstrat **3** und mehrere MEMS-Elemente **11** in Form eines MEMS-Element-Arrays **15,** wobei die hier dargestellten MEMS-Elemente **11** akustische MEMS-wandler (MEMS-Mikrofone und/oder MEMS-Lautsprecher) bilden. Die MEMS-Elemente **11** liegen zumindest teilweise in dem Packagesubstrat **3** eingebettet vor, sodass der Interaktionsbereich eines jeden MEMS-Elementes **11** (hier insbesondere die schwingfähige Membran der MEMS-Mikrofone) frei bleibt. Auf dem Packagesubstrat **3** liegen Antennen **7** zum Senden und/oder Empfangen von elektromagnetischen Signalen vor. Die Antennen **7** liegen als Antennenarray **9** vor. Hierbei fungiert das Packagesubstrat **3** als Antennensubstrat für die Antennen **7.**

Die Erfinder haben erkannt, dass somit das Packagesubstrat **3** für MEMS-Elemente **11** gleichzeitig als Antennensubstrat **3** fungieren kann. Gleichwohl kann auch ein Antennensubstrat **3** als Packagesubstrat **3** verwendet werden. Dies stellt eine Abkehr zum Stand der Technik dar, wonach Antennen auf ein Antennensubtrat umfassend ein dielektrisches Material aufgebracht werden, während das Packagesubstrat **3** für MEMS-Elemente **11** lediglich zur Erfüllung einer Gehäuse-bzw. Schutzfunktion eingesetzt wird. Erfindungsgemäß wurde jedoch erkannt, dass durch das Packagesubstrat **3** Anforderungen für MEMS-Elemente **11** und für Antennen **7** gleichermaßen erfüllt werden können.

Das MEMS-Package **1** kann durch die Anbringung von Antennen **7** und MEMS-Wandlern **11** in eine Vielzahl von Anwendungen vorteilhafterweise eingesetzt werden, in denen ein Austausch und/oder eine Verarbeitung von akustischen und/oder elektromagnetischen Signalen zu erfolgen sind. Vorteilhaft weist das MEMS-Package **1** eine besonders kompakte Ausgestaltung vor, wobei vorzugsweise eine monolithische Integration von MEMS-Wandlern **11** und Antennen **7** auf oder in demselben Packagesubstrat **3** erfolgt. Weiterhin eignet sich das MEMS-Package **1** vorteilhaft zur effizienten Integration in eine Vielzahl von Geräten durch die kompakte geometrische Form des Packagesubstrates **3,** die durch Herstellungsverfahren, beispielsweise durch eine additive Fertigung, angepasst werden kann.

Das in der **Fig. 1** dargestellte MEMS-Package **1** umfasst ein Packagesubstrat **3** umfassend Niedertemperatur-Einbrand-Keramik (LTCC). LTCC eignet sich besonders gut erwiesen, um die dielektrischen Funktionen zu erfüllen und als Antennensubstrat zu fungieren. Gleichzeitig dient das Packagesubstrat **3** zur Erfüllung einer Schutzfunktion für die MEMS-Elemente **11.** Weiterhin ist LTCC hervorragend dazu geeignet, um in eine Anlage zur Ausführung eines additiven Fertigungsverfahrens eingesetzt zu werden, um das Packagesubstrat **3** bereitzustellen. Mithin kann eine erwünschte und präzise geometrische Ausgestaltung des Packagesubstrates **3** erzielt werden.

Insbesondere weist das Packagesubstrat **3** planare und nicht-planare Abschnitte auf, wobei die nicht-planaren Abschnitte in Fig. 1 vorliegend als konkave Abschnitte vorliegen. Die MEMS-Elemente **11** sind innerhalb eines konkaven Abschnitts des Packagesubstrates **3** eingebettet und die Antennen **7** liegen ebenfalls auf einem weiteren konkaven Abschnitt vor. Vorteilhaft können besonders durch die Anbringung auf einem konkaven Abschnitt durch die MEMS-Wandler besonders präzise und gebündelt akustische Signale empfangen und/oder gesendet werden und durch die Antennen besonders präzise und gebündelt elektromagnetische Signale empfangen und/oder versendet werden.

Die MEMS-Elemente **11** befinden sich innerhalb von Ausnehmungen des Packagesubstrates **3,** sodass die MEMS-Elemente **11** vorteilhaft auf robuste Weise innerhalb des Packagesubstrates **3** eingebettet sind. Weiterhin bietet auch die Ausnehmung ein ausreichendes Rückvolumen für einen MEMS-Wandler **11,** sodass vorteilhaft die akustischen Eigenschaften als solche durch die Ausnehmung begünstigt werden können.

Zudem ist eine Recheneinheit **5** auf dem Packagesubstrat **3** angebracht. Die Recheneinheit **5** ist dazu konfiguriert, Daten der Antennen **7** und/oder der MEMS-Wandler **11** zu verarbeiten, beispielsweise für ein Beamforming zur Verstärkung und Erlangung einer Richtwirkung von empfangenen und/oder versenden elektromagnetischen und/oder akustischen Signalen.

Durch Leiterbahnen **13,** die innerhalb des Packagesubstrates **3** eingebracht vorliegen, liegt eine Datenverbindung zwischen den MEMS-Wandlern **11,** der Recheneinheit **5** und/oder der Antennen **9** vor. Somit kann ein Datenaustausch zwischen den benannten Komponenten durch die Leiterbahnen **13** erfolgen.

**Fig. 2** stellt eine schematische Darstellung der Wirkungsweise des MEMS-Packages **1** dar. Die Recheneinheit **5** soll durch die Begriffe "Logik" und "Verteilnetzwerk" veräußert werden, da die Recheneinheit **5** dazu konfiguriert ist, Rechenoperationen auszuführen zur Verarbeitung von versendeten und/oder empfangenen elektromagnetischen und/oder akustischen Signalen. Insbesondere soll durch das Verteilnetzwerk betont werden, dass eine Ansteuerung der Antennen **7** ermöglicht wird, beispielsweise zur Anpassung der Positionierung und/oder der Richtung zum Senden und/oder Empfangen von elektromagnetischen Signalen. Beispielsweise kann im Rahmen einer Lokalisierung eine Grobschätzung mithilfe empfangener akustischer Signale erfolgen, während die Antennen **7** entsprechend ausgerichtet werden und für eine Feinschätzung eingesetzt werden können. Mithin kann durch das MEMS-Package **1** geeignete Anwendungszwecke erfüllt werden, die auf eine Verarbeitung von elektromagnetischen und akustischen Signalen beruhen. Folglich kann eine Verbesserung hinsichtlich der Lokalisierung vorgenommen werden, bspw. durch eine wechselseitige Verarbeitung von elektromagnetischen und akustischen Signalen.

**Fig. 3** stellt eine weitere schematische Darstellung einer Ausführungsform des MEMS-Packages **1** dar. In dieser Ausführungsform des MEMS-Packages **1** befinden sich MEMS-Wandler **11** sowie die Antennen **7** auf demselben nicht-planaren Abschnitt des Packagesubstrates **3.** Der nicht-planare Abschnitt weist eine konkave Ausgestaltung auf. Durch die Anbringung von MEMS-Mikrofonen **11** und Antennen **7** auf oder innerhalb desselben konkaven Abschnitts ergibt sich eine besonders kompakte Anordnung der Komponenten, die auch vorteilhaft herstellungseffizient bereitgestellt werden kann.

### BEZUGSZEICHENLISTE

- 1: MEMS-Package
- 3: Packagesubstrat
- 5: Recheneinheit
- 7: Antenne
- 9: Antennenarray
- 11: MEMS-Element
- 13: Leiterbahn
- 15: MEMS-Element-Array

### LITERATURVERZEICHNIS

Izadpanah Toos, Saber & Moradi, Ghazal & Ebrahimi, Amir. (2019). MEMS packaging review. 10.13140/RG.2.2.17074.35522.
Dehé, A., Wurzer, M., Füldner, M., & Krumbein, U. (2013). A4. 3-The infineon silicon MEMS microphone. Proceedings Sensor 2013, 95-99.
Stanimirović, Ivanka, and Zdravko Stanimirović (2014). "MEMS Packaging: Material Requirements and Reliability."
Pozar, David M. "A review of aperture coupled microstrip antennas: History, operation, development, and applications." University of Massachusetts at Amherst (1996): 1-9.
Kumar, Arvind, and S. Raghavan. "A review: substrate integrated waveguide antennas and arrays." Journal of Telecommunication, Electronic and Computer Engineering (JTEC) 8.5 (2016): 95-104.
Bozzi, Maurizio, Anthimos Georgiadis, and Kaijie Wu. "Review of substrate-integrated waveguide circuits and antennas." IET Microwaves, Antennas & Propagation 5.8 (2011): 909-920.

## Patentansprüche

1. MEMS-Package (1) umfassend
a. ein Packagesubstrat (3),
b. mindestens ein MEMS-Element (11) umfassend einen MEMS-Interaktionsbereich, wobei das mindestens eine MEMS-Element (11) in dem Packagesubstrat (3) mindestens teilweise eingebettet vorliegt, sodass mindestens der MEMS-Interaktionsbereich frei bleibt,
wobei
auf dem Packagesubstrat (3) eine oder mehrere Antennen (7) zum Senden und/oder Empfangen von elektromagnetischen Signalen vorliegen, wobei das Packagesubstrat (3) als Antennensubstrat für die eine oder mehreren Antennen (7) fungiert, wobei das Packagesubstrat (3) in dem MEMS-Package (1) eine Gehäuse- und/oder Schutzfunktion für das mindestens eine MEMS-Element (11) erfüllt und gleichzeitig eine Wirkverbindung mit einer Umgebung vorliegt, sodass das mindestens eine MEMS-Element (11) ein Signal aus der Umgebung empfangen und/oder in die Umgebung versenden kann, **dadurch gekennzeichnet, dass** das mindestens eine MEMS-Element (11) und/oder die eine oder mehreren Antennen (7) auf einem nicht-planaren Abschnitt vorliegt.

2. MEMS-Package (1) nach dem vorherigen Anspruch
**dadurch gekennzeichnet, dass**
das Packagesubstrat (3) ein dielektrisches Material umfasst,
wobei bevorzugt das dielektrische Material ausgewählt ist aus einer Gruppe umfassend Niedertemperatur-Einbrand-Keramik, LTCC, und/oder Hochtemperatur-Mehrlagenkeramik, HTCC.

3. MEMS-Package (1) nach einem oder mehreren der vorherigen Ansprüche
**dadurch gekennzeichnet, dass**
das Packagesubstrat (3) ein dielektrisches Material umfasst, wobei das Material eine relative Permittivität εᵣ von größer 1 aufweist, bevorzugt zwischen 1 - 10, besonders bevorzugt zwischen 2 - 8, ganz besonders bevorzugt zwischen 5 - 10.

4. MEMS-Package (1) nach einem oder mehreren der vorherigen Ansprüche
**dadurch gekennzeichnet, dass**
das MEMS-Package (1) eine Recheneinheit (5) aufweist, welche vorzugsweise auf oder in dem Packagesubstrat (3) vorliegt.

5. MEMS-Package (1) nach einem oder mehreren der vorherigen Ansprüche
**dadurch gekennzeichnet, dass**
die eine oder mehreren Antennen (7) als Patchantennen vorliegen.

6. MEMS-Package (1) nach einem oder mehreren der vorherigen Ansprüche
**dadurch gekennzeichnet, dass**
das MEMS-Package (1) mehrere Antennen (7) in Form eines Antennenarrays (9) aufweist, wobei bevorzugt das Antennenarray (9) mindestens 2, 3, 4, 5, 6, 7, 8, 9, 10 oder mehr Antennen (7) umfasst.

7. MEMS-Package (1) nach einem oder mehreren der vorherigen Ansprüche
**dadurch gekennzeichnet, dass**
das mindestens eine MEMS-Element (11) ausgewählt ist aus einer Gruppe umfassend einen MEMS-Wandler, bevorzugt ein MEMS-Mikrofon (11) oder ein MEMS-Lautsprecher, und/oder ein MEMS-Sensor, bevorzugt ein MEMS-Flusssensor oder ein MEMS-Gassensor.

8. MEMS-Package (1) nach einem oder mehreren der vorherigen Ansprüche
**dadurch gekennzeichnet, dass**
in dem Packagesubstrat (3) mindestens teilweise ein MEMS-Element-Array umfassend mehrere MEMS-Elemente (11) eingebettet vorliegt,
wobei bevorzugt das MEMS-Element-Array (15) mindestens 2, 3, 4, 5, 6, 7, 8, 9. 10 oder mehr MEMS-Elemente (11) umfasst und/oder
wobei bevorzugt das MEMS-Element-Array (15) ein MEMS-Mikrofon-Array und/oder ein MEMS-Lautsprecher-Array umfasst.

9. MEMS-Package (1) nach einem oder mehreren der vorherigen Ansprüche
**dadurch gekennzeichnet, dass**
das Packagesubstrat (3) eine Packagesubstratoberfläche umfasst, wobei die Packagesubstratoberfläche mindestens teilweise einen planaren und/oder nicht-planaren Abschnitt aufweist, wobei bevorzugt der nicht-planare Abschnitt eine konkave oder konvexe Ausgestaltung umfasst.

10. MEMS-Package (1) nach einem oder mehreren der vorherigen Ansprüche
**dadurch gekennzeichnet, dass**
das mindestens eine MEMS-Element (11) und die eine oder mehreren Antennen (7) auf demselben nicht-planaren Abschnitt vorliegen.

11. MEMS-Package (1) nach einem oder mehreren der vorherigen Ansprüche m
**dadurch gekennzeichnet, dass**
das Packagesubstrat (3) eine oder mehrere Ausnehmungen aufweist, wobei das mindestens eine MEMS-Element (11) innerhalb der einen oder mehreren Ausnehmungen vorliegt.

12. MEMS-Package (1) nach einem oder mehreren der vorherigen Ansprüche
**dadurch gekennzeichnet, dass**
das mindestens eine MEMS-Element und/oder die eine oder mehreren Antennen (7) sowie optional eine Recheneinheit (5) miteinander über Leiterbahnen (13) und/oder Durchkontaktierungen verbunden sind,
wobei bevorzugt zumindest teilweise die Leiterbahnen (13) und/oder die Durchkontaktierungen innerhalb des Packagesubstrates (3) angebracht sind.

13. MEMS-Package (1) nach einem oder mehreren der vorherigen Ansprüche
**dadurch gekennzeichnet, dass**
das Packagesubstrat (3) ein MEMS-Wandler-Array (15) aufweist, bevorzugt ein MEMS-Mikrofon-Array und/oder ein MEMS-Lautsprecher-Array, und ein Antennenarray (9) auf dem Packagesubstrat (3) vorliegt sowie die Recheneinheit (5) dazu konfiguriert ist, dass das Antennenarray (9) elektromagnetische Signale und/oder das MEMS-Wandler-Array (15) akustische Signale mittels Beamforming sendet und/oder empfängt.

14. MEMS-Package (1) nach dem vorherigen Anspruch
**dadurch gekennzeichnet, dass**
MEMS-Package (1) eine Recheneinheit (5) umfasst, welche dazu konfiguriert ist, dass für das Beamforming eine wechselseitige Verarbeitung der elektromagnetischen Signale und der akustischen Signale vorgenommen wird, wobei die Recheneinheit (5) bevorzugt dazu konfiguriert ist, eine Lokalisierung von Objekten und/oder Nutzern über empfangene und/oder gesendete elektromagnetische Signale und akustische Signale vorzunehmen.

15. Verfahren zur Herstellung eines MEMS-Packages (1) nach einem oder mehreren der vorherigen Ansprüche umfassend folgende Schritte:
a) Bereitstellung eines Packagesubstrates (3) und/oder von Leiterbahnen (13) durch ein additives Fertigungsverfahren, bevorzugt ein multimaterielles additives Fertigungsverfahren,
b) mindestens teilweise Einbettung mindestens eines MEMS-Elements (11) umfassend einen MEMS-Interaktionsbereich, sodass zumindest der MEMS-Interaktionsbereich frei bleibt,
c) Anbringung einer oder mehrerer Antennen (7) auf dem Packagesubstrat (3),
d) optionale Anbringung einer Recheneinheit (5) auf oder in dem Packagesubstrat (3).

## Claims

1. MEMS package (1) comprising
a. a package substrate (3),
b. at least one MEMS element (11) comprising a MEMS interaction region, wherein the at least one MEMS element (11) is present at least partially embedded in the package substrate (3), such that at least the MEMS interaction region remains free,
wherein one or more antennas (7) for transmitting and/or receiving electromagnetic signals are present on the package substrate (3), wherein the package substrate (3) functions as an antenna substrate for the one or more antennas (7), wherein the package substrate (3) in the MEMS package (1) fulfills a housing and/or protective function for the MEMS element (11) and at a same time an active connection with an environment is present, such that the at least one MEMS element (11) can receive a signal from the environment and/or transmit a signal to the environment
**characterized in that**
the at least one MEMS element (11) and/or the one or more antennas (7) are present on a non-planar section.

2. MEMS package (1) according to the previous claim
**characterized in that**
the package substrate (3) comprises a dielectric material,
wherein preferably the dielectric material is selected from a group comprising low temperature cofired ceramics, LTCC, and/or high-temperature cofired ceramics, HTCC.

3. MEMS package (1) according to one or more of the preceding claims
**characterized in that**
the package substrate (3) comprises a dielectric material, wherein the material exhibits a relative permittivity εᵣ of greater than 1, preferably between 1 - 10, particularly preferably between 2 - 8, very particularly preferably between 5 - 10.

4. MEMS package (1) according to one or more of the preceding claims
**characterized in that**
the MEMS package (1) exhibits a computing unit (5), which is preferably present on or in the package substrate (3).

5. MEMS package (1) according to one or more of the preceding claims
**characterized in that**
one or more antennas (7) are present as patch antennas.

6. MEMS package (1) according to one or more of the preceding claims
**characterized in that**
the MEMS package (1) comprises a plurality of antennas (7) in the form of an antenna array (9), wherein the antenna array (9) preferably comprises at least 2, 3, 4, 5, 6, 7, 8, 9, 10 or more antennas (7).

7. MEMS package (1) according to one or more of the preceding claims
**characterized in that**
the at least one MEMS element (11) is selected from a group comprising a MEMS transducer, preferably a MEMS microphone (11) or a MEMS loudspeaker, and/or a MEMS sensor, preferably a MEMS flow sensor or a MEMS gas sensor.

8. MEMS package (1) according to one or more of the preceding claims
**characterized in that**
a MEMS element array comprising a plurality of MEMS elements (11) is present at least partially embedded in the package substrate (3),
wherein preferably the MEMS element array (15) comprises at least 2, 3, 4, 5, 6, 7, 8, 9, 10 or more MEMS elements (11) and/or
wherein preferably the MEMS element array (15) comprises a MEMS microphone array and/or a MEMS loudspeaker array.

9. MEMS package (1) according to one or more of the preceding claims
**characterized in that**
the package substrate (3) comprises a package substrate surface, wherein the package substrate surface exhibits at least partially a planar and/or non-planar section, wherein preferably the non-planar section comprises a concave or convex configuration.

10. MEMS package (1) according to one or more of the preceding claims
**characterized in that**
the at least one MEMS element (11) and the one or more antennas (7) are present on the same non-planar section.

11. MEMS package (1) according to one or more of the preceding claims m
**characterized in that**
the package substrate (3) exhibits one or more recesses, wherein the at least one MEMS element (11) is present within the one or more recesses.

12. MEMS package (1) according to one or more of the preceding claims
**characterized in that**
the at least one MEMS element and/or the one or more antennas (7) and optionally a computing unit (5) are connected to one another by means of conductor tracks (13) and/or vias,
wherein preferably the conductor tracks (13) and/or the vias are at least partially provided within the package substrate (3).

13. MEMS package (1) according to one or more of the preceding claims
**characterized in that**
the package substrate (3) exhibits a MEMS transducer array (15), preferably a MEMS microphone array and/or a MEMS loudspeaker array, and an antenna array (9) is present on the package substrate (3) and the computing unit (5) is configured such that the antenna array (9) transmits and/or receives electromagnetic signals and/or the MEMS transducer array (15) transmits and/or receives acoustic signals by means of beamforming.

14. MEMS package (1) according to the preceding claim
**characterized in that**
MEMS package (1) comprises a computing unit (5) which is configured to perform reciprocal processing of the electromagnetic signals and the acoustic signals for beamforming,
wherein the computing unit (5) is preferably configured to perform a localization of objects and/or users via received and/or transmitted electromagnetic signals and acoustic signals.

15. A method for producing a MEMS package (1) according to one or more of the preceding claims, comprising the following steps:
a) provision of a package substrate (3) and/or conductor tracks (13) by an additive manufacturing process, preferably a multi-material additive manufacturing process,
b) at least partial embedding of at least one MEMS element (11) comprising a MEMS interaction region, such that at least the MEMS interaction region remains free,
c) mounting of one or more antennas (7) on the package substrate (3),
d) optional mounting of a computing unit (5) on or in the package substrate (3).

## Revendications

1. Boîtier MEMS (1) comprenant
a. un substrat de boîtier (3),
b. au moins un élément MEMS (11) comprenant une zone d'interaction MEMS, dans lequel l'au moins un élément MEMS (11) est incorporé au moins partiellement dans le substrat de boîtier (3) de sorte qu'au moins la zone d'interaction MEMS reste libre, dans lequel une ou plusieurs antennes (7) sont présentes sur le substrat de boîtier (3) pour l'émission et/ou la réception de signaux électromagnétiques, dans lequel le substrat de boîtier (3) agit comme substrat d'antenne pour les une ou plusieurs antennes (7), dans lequel le substrat de boîtier (3) remplit dans le boîtier MEMS (1) une fonction de boîtier et/ou de protection pour l'au moins un élément MEMS (11) et une liaison active avec un environnement est en même temps présente, de sorte que l'au moins un élément MEMS (11) peut recevoir un signal en provenance de l'environnement et/ou envoyer un signal dans l'environnement, **caractérisé en ce que** l'au moins un élément MEMS (11) et/ou les une ou plusieurs antennes (7) sont présents sur une section non plane.

2. Boîtier MEMS (1) selon la revendication précédente
**caractérisé en ce que**
le substrat de boîtier (3) comprend un matériau diélectrique, de préférence dans lequel le matériau diélectrique est choisi dans un groupe comprenant la céramique à cuisson basse température, LTCC, et/ou la céramique multicouche haute température, HTCC.

3. Boîtier MEMS (1) selon l'une ou plusieurs des revendications précédentes
**caractérisé en ce que**
le substrat de boîtier (3) comprend un matériau diélectrique, dans lequel le matériau présente une permittivité relative εᵣ supérieure à 1, de préférence comprise entre 1 et 10, de manière particulièrement préférée entre 2 et 8, de manière tout particulièrement préférée entre 5 et 10.

4. Boîtier MEMS (1) selon l'une ou plusieurs des revendications précédentes
**caractérisé en ce que**
le boîtier MEMS (1) présente une unité de calcul (5) qui est présente de préférence sur ou dans le substrat de boîtier (3).

5. Boîtier MEMS (1) selon l'une ou plusieurs des revendications précédentes
**caractérisé en ce que**
une ou plusieurs antennes (7) sont présentes sous forme d'antennes patch.

6. Boîtier MEMS (1) selon l'une ou plusieurs des revendications précédentes
**caractérisé en ce que**
le boîtier MEMS (1) présente plusieurs antennes (7) sous la forme d'un réseau d'antennes (9), dans lequel le réseau d'antennes (9) comprend de préférence au moins 2, 3, 4, 5, 6, 7, 8, 9, 10 antennes (7) ou plus.

7. Boîtier MEMS (1) selon l'une ou plusieurs des revendications précédentes
**caractérisé en ce que**
l'au moins un élément MEMS (11) est sélectionné dans un groupe comprenant un convertisseur MEMS, de préférence un microphone MEMS (11) ou un haut-parleur MEMS, et/ou un capteur MEMS, de préférence un capteur de flux MEMS ou un capteur de gaz MEMS.

8. Boîtier MEMS (1) selon l'une ou plusieurs des revendications précédentes
**caractérisé en ce que**
un réseau d'éléments MEMS comprenant plusieurs éléments MEMS (11) est incorporé au moins partiellement dans le substrat de boîtier (3),
dans lequel, de préférence, le réseau d'éléments MEMS (15) comprend au moins 2, 3, 4, 5, 6, 7, 8, 9, 10 ou plus éléments MEMS (11) et/ou
dans lequel, de préférence, le réseau d'éléments MEMS (15) comprend un réseau de microphones MEMS et/ou un réseau de haut-parleurs MEMS.

9. Boîtier MEMS (1) selon l'une ou plusieurs des revendications précédentes
**caractérisé en ce que**
le substrat de boîtier (3) comprend une surface de substrat d'emballage, dans lequel la surface de substrat d'emballage présente au moins partiellement une section plane et/ou non plane, dans lequel la section non plane comprend de préférence une configuration concave ou convexe.

10. Boîtier MEMS (1) selon l'une ou plusieurs des revendications précédentes
**caractérisé en ce que**
l'au moins un élément MEMS (11) et les une ou plusieurs antennes (7) sont présentes sur la même section non plane.

11. Boîtier MEMS (1) selon l'une ou plusieurs des revendications précédentes
**caractérisé en ce que**
le substrat de boîtier (3) présente un ou plusieurs évidements, dans lequel l'au moins un élément MEMS (11) est présent à l'intérieur des un ou plusieurs évidements.

12. Boîtier MEMS (1) selon l'une ou plusieurs des revendications précédentes
**caractérisé en ce que**
l'au moins un élément MEMS et/ou les une ou plusieurs antennes (7) et, en option, une unité de calcul (5) sont reliés les uns aux autres par des pistes conductrices (13) et/ou des trous métallisés,
dans lequel, de préférence, les pistes conductrices (13) et/ou les trous métallisés sont disposés au moins partiellement à l'intérieur du substrat de boîtier (3).

13. Boîtier MEMS (1) selon l'une ou plusieurs des revendications précédentes
**caractérisé en ce que**
le substrat de boîtier (3) présente un réseau de convertisseurs MEMS (15), de préférence un réseau de microphones MEMS et/ou un réseau de haut-parleurs MEMS, et un réseau d'antennes (9) est présent sur le substrat de boîtier (3), et l'unité de calcul (5) est configurée pour que le réseau d'antennes (9) envoie et/ou reçoive des signaux électromagnétiques et/ou que le réseau de convertisseurs MEMS (15) envoie et/ou reçoive des signaux acoustiques par formation de faisceaux.

14. Boîtier MEMS (1) selon la revendication précédente
**caractérisé en ce que**
le boîtier MEMS (1) comprend une unité de calcul (5) qui est configurée pour qu'un traitement mutuel des signaux électromagnétiques et des signaux acoustiques soit effectué pour la formation de faisceaux, dans lequel l'unité de calcul (5) est configurée de préférence pour effectuer une localisation d'objets et/ou d'utilisateurs par l'intermédiaire de signaux électromagnétiques et de signaux acoustiques reçus et/ou envoyés.

15. Procédé de fabrication d'un boîtier MEMS (1) selon l'une ou plusieurs des revendications précédentes, comprenant les étapes suivantes :
a) la mise à disposition d'un substrat de boîtier (3) et/ou de pistes conductrices (13) par un procédé de fabrication additive, de préférence un procédé de fabrication additive multimatériel,
b) l'incorporation au moins partielle d'au moins un élément MEMS (11) comprenant une zone d'interaction MEMS, de sorte qu'au moins la zone d'interaction MEMS reste libre,
c) la mise en place d'une ou de plusieurs antennes (7) sur le substrat de boîtier (3),
d) la pose facultative d'une unité de calcul (5) sur ou dans le substrat de boîtier (3).
